# EUROPEAN PATENT APPLICATION

(11) **EP 4 475 188 A1**
(43) Date of publication of application: **11.12.2024**
(21) Application number: 23749471.1
(22) Date of filing: 05.01.2023
(51) Int. Cl.: H01L 27/146, H04N 25/10, H04N 25/70

(54) **SOLID-STATE IMAGING ELEMENT AND ELECTRONIC APPARATUS**

(30) Priority: 03.02.2022 JP 2022015503
(71) Applicant: Sony Semiconductor Solutions Corporation, Atsugi-shi, Kanagawa 243-0014 (JP)
(72) Inventor: KUTSUKAKE, Hirotaka, Kikuchi-gun, Kumamoto 869-1102 (JP); TAKAHASHI, Ryo, Kikuchi-gun, Kumamoto 869-1102 (JP); OZAKI, Kosuke, Kikuchi-gun, Kumamoto 869-1102 (JP); OHURA, Masashi, Kikuchi-gun, Kumamoto 869-1102 (JP); MORIYAMA, Suguru, Kikuchi-gun, Kumamoto 869-1102 (JP)
(74) Representative: MFG Patentanwälte Meyer-Wildhagen Meggle-Freund Gerhard PartG mbB
(86) International application number: PCT/JP2023/000103
(87) International publication number: WO 2023/149154

(57) **Abstract**

A solid-state imaging element includes: a photoelectric conversion unit that performs photoelectric conversion; and a color filter that is formed on a light incident side of the photoelectric conversion unit and selectively transmits light received by the photoelectric conversion unit, in which a void and a light shielding film on the light incident side of the void are formed between a plurality of the color filters.

## Description

### TECHNICAL FIELD

The present technology relates to a technology of a solid-state imaging element including a plurality of sound pixels arranged, and an electronic device.

### BACKGROUND ART

A solid-state imaging element including a plurality of pixels arranged is widely used, the pixels receiving incident light and performs photoelectric conversion to generate an image signal.

In the solid-state imaging element, a color filter that transmits incident light of a predetermined wavelength is arranged for each pixel, whereby an image signal of a color image can be obtained.

In a solid-state imaging element including a color filter, color mixing occurs and image quality decreases in a case where light incident on a certain pixel passes through a pixel boundary and is incident on an adjacent pixel.

In order to prevent color mixing, for example, Patent Document 1 below discloses a technology of forming a void between color filters.

### CITATION LIST

### PATENT DOCUMENT

Patent Document 1: U.S. Patent Application Publication No. 2019/0157329

### SUMMARY OF THE INVENTION

### PROBLEMS TO BE SOLVED BY THE INVENTION

Since the void has a refractive index lower than that of the color filter, incident light from an adjacent pixel is reflected to the original pixel, whereby an effect of preventing color mixing can be obtained.

However, in the technology disclosed in Patent Document 1 described above, even though color mixing can be prevented, there is a problem that incident light is reflected at an upper portion of the void and flare occurs.

The present technology has been made in view of such a problem, and an object thereof is to improve light receiving sensitivity and to reduce noise due to color mixing or reflection.

### SOLUTIONS TO PROBLEMS

A solid-state imaging element according to the present technology includes: a photoelectric conversion unit that performs photoelectric conversion; and a color filter that is formed on a light incident side of the photoelectric conversion unit and selectively transmits light received by the photoelectric conversion unit, in which a void and a light shielding film on the light incident side of the void are formed between a plurality of the color filters.

As a result, the void is formed between the color filters, whereby total reflection occurs for light incident from a side surface of the void. Then, due to the light shielding film above the void, light incident from above on a boundary portion of the color filter is blocked by the light shielding film.

An electronic device according to the present technology includes: an optical system element on which light is incident; a solid-state imaging element that receives light incident from the optical system element and outputs a pixel signal according to an amount of received light; and a signal processing unit that performs signal processing on the pixel signal, in which the solid-state imaging element includes: a photoelectric conversion unit that performs photoelectric conversion; and a color filter that is formed on a light incident side of the photoelectric conversion unit and selectively transmits light received by the photoelectric conversion unit, and a void and a light shielding film on the light incident side of the void are formed between a plurality of the color filters.

### BRIEF DESCRIPTION OF DRAWINGS

Fig. 1 is a diagram illustrating a configuration example of a solid-state imaging element of the present technology.
Fig. 2 is a cross-sectional view of the solid-state imaging element in a first embodiment.
Fig. 3 is a diagram for explaining incident light incident on the solid-state imaging element, and reflected light and transmitted light thereof.
Fig. 4 is a diagram for explaining a manufacturing step of the solid-state imaging element illustrated together with Figs. 4 to 10, and Fig. 4 is a diagram illustrating a state in which a wiring layer and a photodiode are formed on a semiconductor substrate.
Fig. 5 is a diagram illustrating a state in which an insulating layer is formed on a back surface side of the semiconductor substrate.
Fig. 6 is a diagram illustrating a state in which a color filter is formed on the back surface side of the insulating layer.
Fig. 7 is a diagram illustrating a state in which a resist is applied between color filters and on an upper surface side.
Fig. 8 is a diagram illustrating a state in which the resist is irradiated with light.
Fig. 9 is a diagram illustrating a state in which the resist is removed and a light shielding film is formed.
Fig. 10 is a diagram illustrating a state in which an on-chip lens is attached to the back surface side of the color filter and the light shielding film.
Fig. 11 is a diagram illustrating a solid-state imaging element as a conventional example.
Fig. 12 is a diagram illustrating a state in which incident light is incident from above the light shielding film in the solid-state imaging element of the present technology.
Fig. 13 is a diagram illustrating a simulation result regarding a result of suppressing color mixing based on incident light.
Fig. 14 is a diagram illustrating a state in which light parallel to an optical axis is incident from above the light shielding film in the solid-state imaging element of the present technology.
Fig. 15 is a diagram illustrating a simulation result regarding an effect of suppressing flare based on incident light.
Fig. 16 is a diagram illustrating a solid-state imaging element as another conventional example.
Fig. 17 is a diagram illustrating a state in which incident light is incident from above the light shielding film in the solid-state imaging element of the present technology.
Fig. 18 is a diagram illustrating a simulation result regarding light receiving sensitivity.
Fig. 19 is a cross-sectional view of a solid-state imaging element including a void having a forward tapered shape in a second embodiment.
Fig. 20 is a cross-sectional view of the solid-state imaging element including a void having a reverse tapered shape in the second embodiment.
Fig. 21 is a diagram for explaining a relationship between an image height and a tapered shape of a void.
Fig. 22 is a diagram for explaining an arrangement example of first pixels, second pixels, and third pixels.
Fig. 23 is a diagram for explaining an arrangement example of the first pixels and the second pixels.
Fig. 24 is a diagram for explaining an arrangement example of the first pixels and the third pixels.
Fig. 25 is a diagram for explaining an example in which the forward tapered shape of the void differs for each type of the color filter.
Fig. 26 is a diagram for explaining an example in which the reverse tapered shape of the void differs for each type of the color filter.
Fig. 27 is a diagram for explaining an example in which a corner portion of the void has a rounded shape.
Fig. 28 is a cross-sectional view of a solid-state imaging element including a metal film in a third embodiment.
Fig. 29 is a diagram for explaining a state in which incident light is blocked by the metal film.
Fig. 30 is a diagram for explaining a manufacturing step of the solid-state imaging element in the second embodiment illustrated together with Figs. 30 to 33, and Fig. 30 is a diagram illustrating a state in which a metal layer having a film shape is formed on the back surface side of the insulating layer.
Fig. 31 is a diagram illustrating a state in which a resist is applied to the back surface side of the metal layer.
Fig. 32 is a diagram illustrating a state in which the metal film from which a part of the metal film is removed is formed by etching.
Fig. 33 is a diagram illustrating a state in which the color filters are arranged.
Fig. 34 is a diagram illustrating a state in which a resist is applied so as to cover a color filter in a procedure of a manufacturing method in a fourth embodiment.
Fig. 35 is a cross-sectional view of a solid-state imaging element including a light shielding film in the fourth embodiment.
Fig. 36 is a functional block diagram of an imaging apparatus as an electronic device to which the solid-state imaging element of the present technology is applied.

### MODE FOR CARRYING OUT THE INVENTION

Hereinafter, an embodiment according to the present technology will be described in the following order with reference to the accompanying drawings.
<1. Configuration of solid-state imaging element>
<2. Configuration of pixel>
<3. Flare and color mixing>
<4. Manufacturing method>
<5. Simulation results>
   <5-1. Color mixing suppression effect by light shielding film>
   <5-2. Flare suppression effect by light shielding film>
   <5-3. Color mixing suppression effect and sensitivity improvement effect by void>
<6. Second embodiment>
<7. Third embodiment>
<8. Fourth embodiment>
<9. Application to camera>
<10. Modifications>
<11. Summary>
<12. Present technology>

### <1. Configuration of solid-state imaging element>

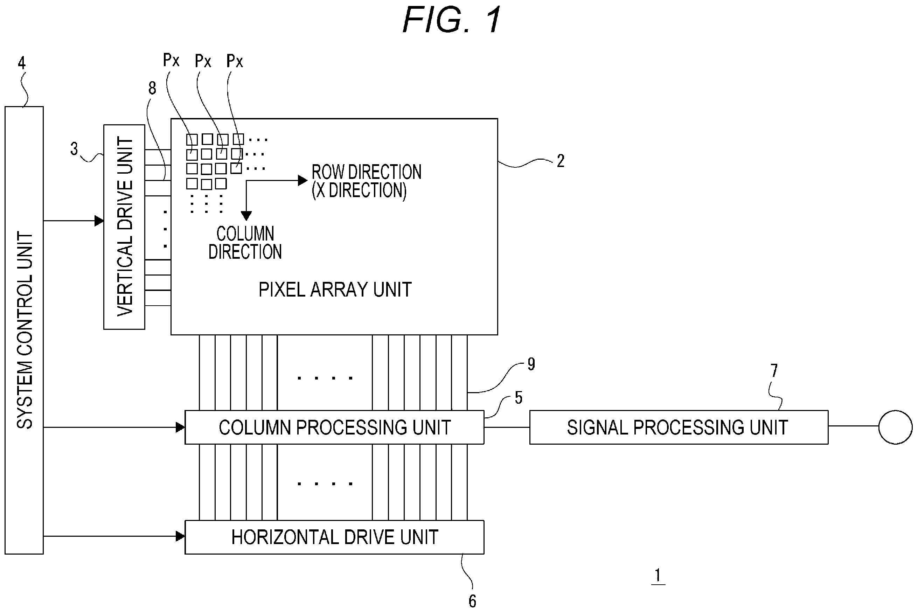

A configuration of a solid-state imaging element 1 in a first embodiment will be described with reference to Fig. 1.

The solid-state imaging element 1 includes a pixel array unit 2, a vertical drive unit 3, a system control unit 4, a column processing unit 5, a horizontal drive unit 6, and a signal processing unit 7.

In the pixel array unit 2, a plurality of pixels Px is two-dimensionally arranged in a matrix in a row direction and a column direction. Each pixel Px includes a photodiode PD as a photoelectric conversion unit.

Here, the row direction refers to an arrangement direction of the pixels Px in a horizontal direction, and the column direction refers to an arrangement direction of the pixels Px in a vertical direction. In the figure, the row direction is a lateral direction, and the column direction is a longitudinal direction. Furthermore, a direction perpendicular to the row direction and the column direction is referred to as an optical axis direction.

The pixel array unit 2 is provided with first pixels Px1 arranged at positions where the image height is low and second pixels Px2 arranged at positions where the image height is high. The second pixels Px2 are arranged on an outer peripheral side from the first pixels Px1 so as to surround the first pixels Px1.

Hereinafter, the first pixels Px1 and the second pixels Px2 will be referred to as the pixels Px in a case of being described without distinction.

In the pixel array unit 2, with respect to a pixel array in a matrix, a row drive line 8 is wired along the row direction for each of pixel rows, and a vertical signal line 9 is wired in the column direction for each of pixel columns. For example, the row drive line 8 transmits a drive signal for driving when signals are read from the pixels Px. One end of the row drive line 8 is connected to an output end corresponding to one of the rows, of the vertical drive unit 3.

The system control unit 4 includes a timing generator that generates various timing signals, and the like, and performs drive control of the vertical drive unit 3, the column processing unit 5, the horizontal drive unit 6, and the like on the basis of the various timing signals generated by the timing generator.

The vertical drive unit 3 includes a shift register, an address decoder, and the like, and drives the pixels Px of the pixel array unit 2 at the same time for all the pixels, in units of rows, or the like. That is, the vertical drive unit 3 constitutes a drive control unit that controls operation of each pixel Px of the pixel array unit 2 together with the system control unit 4 that controls the vertical drive unit 3.

A detection signal output (read) from each pixel Px of the pixel row according to drive control by the vertical drive unit 3, specifically, a signal according to signal charges accumulated in a floating diffusion provided for each pixel Px is input to the column processing unit 5 via a corresponding vertical signal line 9. The column processing unit 5 performs predetermined signal processing on the detection signal read from each pixel Px via the vertical signal line 9, and temporarily holds the detection signal after the signal processing. Specifically, the column processing unit 5 performs noise removal processing, analog to digital (A/D) conversion processing, and the like as the signal processing.

The horizontal drive unit 6 includes a shift register, an address decoder, and the like, and selects in order a unit circuit corresponding to the pixel column in the column processing unit 5. By selective scanning by the horizontal drive unit 6, the detection signals subjected to the signal processing in respective unit circuits in the column processing unit 5 are output in order.

The signal processing unit 7 has at least an arithmetic processing function, and performs various types of signal processing on the detection signals output from the column processing unit 5, and outputs the signals. For example, the signal processing unit 7 may perform only buffering, or may perform black level adjustment, column variation correction, various types of digital signal processing, and the like.

### <2. Configuration of pixel>

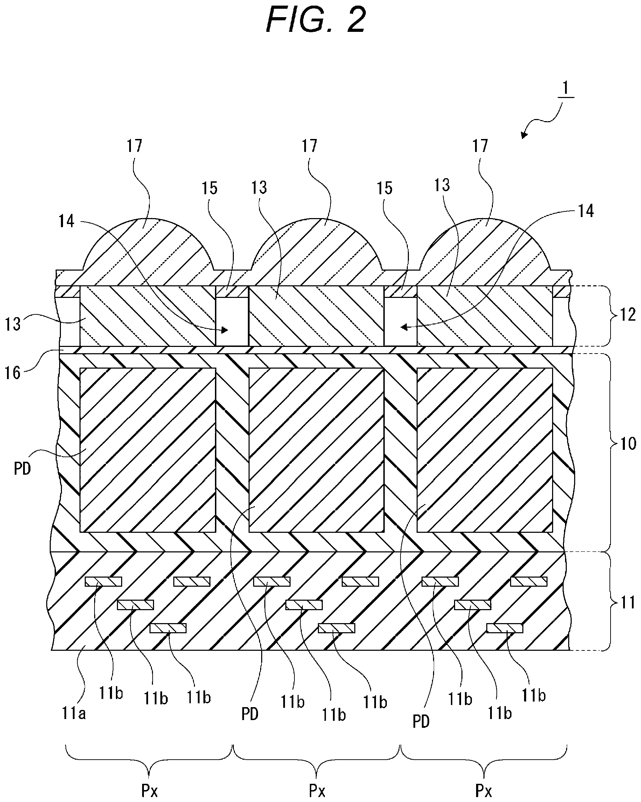

A configuration example of the pixel Px will be described with reference to Fig. 2.

The pixel Px includes a wiring layer 11 formed on an opposite side (for example, a front surface side) from a light incident side of a semiconductor substrate 10 and a filter layer 12 formed on the light incident side (for example, a back surface side) that are formed in layers.

The semiconductor substrate 10 includes silicon (Si) having a thickness of, for example, about 1 µm to 6 µm. Inside the semiconductor substrate 10, the photodiode PD serving as the photoelectric conversion unit is formed in a substantially central portion of the pixel Px.

Specifically, an n-type semiconductor region is disposed on the semiconductor substrate 10 constituting a p-type well region, whereby a diffusion region in the photoelectric conversion unit can be formed. Then, the photodiode PD as the photoelectric conversion unit includes a pn junction including the n-type semiconductor region and the p-type well region.

The wiring layer 11 includes wiring lines 11b stacked in a plurality of layers in the optical axis direction inside an insulating portion 11a including an insulating material.

The wiring lines 11b arranged in different layers are electrically connected to each other as appropriate via a through-hole via (not illustrated) or the like.

Various transistors such as transfer transistors are driven via the wiring lines 11b formed in the wiring layer 11.

Color filters 13 are arranged in the filter layer 12. As the color filters 13, a color filter 13R that transmits only red light, a color filter 13G that transmits only green light, and a color filter 13B that transmits only blue light are provided. The color filters 13 constitute, for example, a Bayer array.

Note that, as the color filters 13, a color filter 13C that transmits only cyan light, a color filter 13M that transmits only magenta light, and a color filter 13Y that transmits only yellow light may be provided. Furthermore, a color filter 13 for a white pixel, and the like are also conceivable.

Between the color filters 13 in the filter layer 12, a void 14, and a light shielding film 15 formed on the light incident side of the void 14 are provided.

The void 14 has a refractive index lower than that of the color filter 13, and thus has a function of guiding incident light to the semiconductor substrate 10. The void 14 is formed in a shape surrounding the color filter 13.

The light shielding film 15 is, for example, a black organic film including a negative resist. As a result, light shielding can be suitably performed, and an effect of suppressing color mixing can be enhanced. Furthermore, reflection of incident light by the light shielding film 15 is suppressed, whereby an effect of suppressing occurrence of flare can be obtained. This will be specifically described later.

Furthermore, the light shielding film 15 is not limited to black, and may be an organic film having a light shielding property or wavelength selectivity. For example, in a case where a light source emits light other than blue light, a negative resist that allows only blue light to pass through is included in the light shielding film 15, whereby the incident light does not pass through the light shielding film 15, so that color mixing can be suppressed.

The light shielding film 15 is provided to shield light incident on an adjacent pixel Px through the void 14, so that a color mixing prevention effect can be obtained. Furthermore, the light shielding film 15 functions as an antireflection film that absorbs incident light, whereby occurrence of flare can be prevented.

An insulating layer 16 and the like are formed between the semiconductor substrate 10 and the filter layer 12. The insulating layer 16 functions as a protective film for protecting the semiconductor substrate 10, and has a function of preventing diffusion of contaminants from the color filter 13 to the semiconductor substrate 10.

The insulating layer 16 includes, for example, an insulator such as SiO2.

The pixel Px includes an on-chip lens 17 on the light incident side of the filter layer 12.

The on-chip lens 17 is formed for each pixel Px on a planarization film (not illustrated) formed on the light incident side in the color filter 13, for example. The on-chip lens 17 has a function of efficiently condensing incident light on the photodiode PD.

The on-chip lens 17 includes an inorganic material such as SiN or an organic material such as an acrylic resin, and is formed in a hemispherical shape.

Note that, although not illustrated, the on-chip lens 17 is disposed so as to be offset in an optical axis center direction as the pixel Px is disposed at a position where the image height is higher, and higher light condensing efficiency can be obtained.

### <3. Flare and color mixing>

An angle of light incident on the pixel Px varies depending on an arrangement position of the pixel Px. Specifically, for the first pixels Px1 arranged at positions where the image height is low, incident light substantially parallel to the optical axis is incident. On the other hand, in the second pixels Px2 arranged at positions where the image height is high, the angle of the incident light with respect to the optical axis increases as the image height is higher.

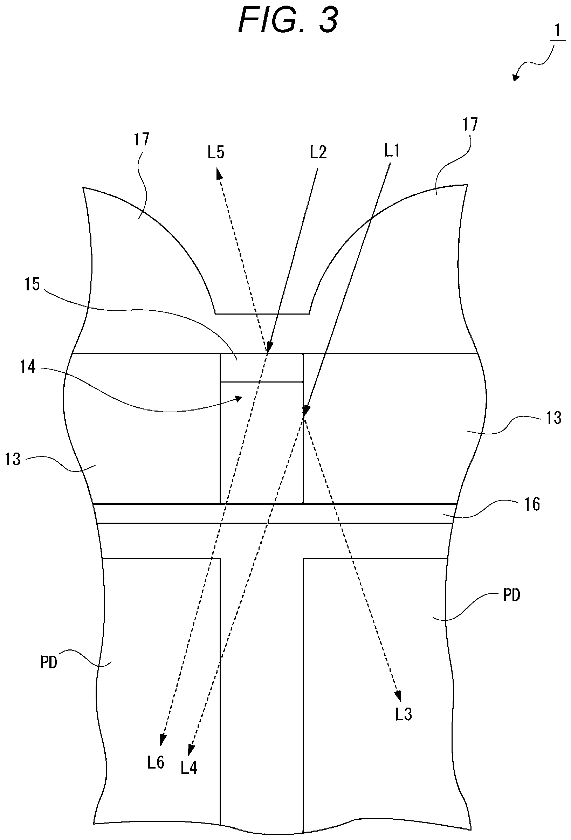

An example of incident light angled with respect to the optical axis is illustrated in Fig. 3. Note that, in Fig. 3, hatching of each part is omitted in consideration of visibility. Also in the following figures, hatching may be omitted as appropriate.

Incident light L1 is light incident on a side surface (boundary with the color filter 13) of the void 14.

The incident light L1 is reflected at the boundary between the color filter 13 and the void 14 (reflected light L3 in Fig. 3), thereby being received by the photodiode PD that should receive the incident light L1 originally. As a result, light receiving sensitivity is improved.

Furthermore, if the incident light L1 travels straight without being reflected at the boundary between the color filter 13 and the void 14 (transmitted light L4 in Fig. 3), the incident light L1 is received by the photodiode PD of the adjacent pixel Px that should not receive the incident light L1 originally. In this case, color mixing occurs in which the incident light L1 is detected as a noise component.

That is, the void 14 is formed between the color filters 13, whereby light incident from the side surface of the void 14 like the incident light L1 is totally reflected easily, and it is possible to make it easier to receive the incident light L1 by the photodiode PD that should receive the incident light L1 originally.

Incident light L2 is light incident on the light shielding film 15 formed on the light incident side of the void 14. If the incident light L2 is reflected at a boundary between the on-chip lens 17 and the filter layer 12 (reflected light L5 in Fig. 3), it becomes a cause of occurrence of flare. Furthermore, if the incident light L2 travels straight without being reflected at the boundary between the on-chip lens 17 and the filter layer 12 (transmitted light L6 in Fig. 3), the incident light L2 is received by the photodiode PD without passing through the color filter 13. In this case, the incident light L2 is detected as a noise component.

The light shielding film 15 is formed above the void 14, whereby reflection and transmission of light incident between the pixels Px like the incident light L2 are suppressed, and occurrence of flare and occurrence of a noise component can be suppressed.

Note that, although a similar effect can be obtained even if the light shielding film 15 is formed below the void 14, that is, on an opposite side from the light incident side, the light shielding film 15 is formed above the void 14, whereby the incident light L2 can be absorbed at a point before unnecessary reflection or the like occurs, which is more suitable for suppressing occurrence of noise, or the like.

As described above, the void 14 and the light shielding film 15 are arranged between the color filters 13, whereby color mixing and the like can be suppressed without adoption of the above-described offset arrangement for the on-chip lens 17.

### <4. Manufacturing method>

An example will be described of a procedure of a method of manufacturing the pixel array unit 2 of the solid-state imaging element 1 with reference to the accompanying drawings.

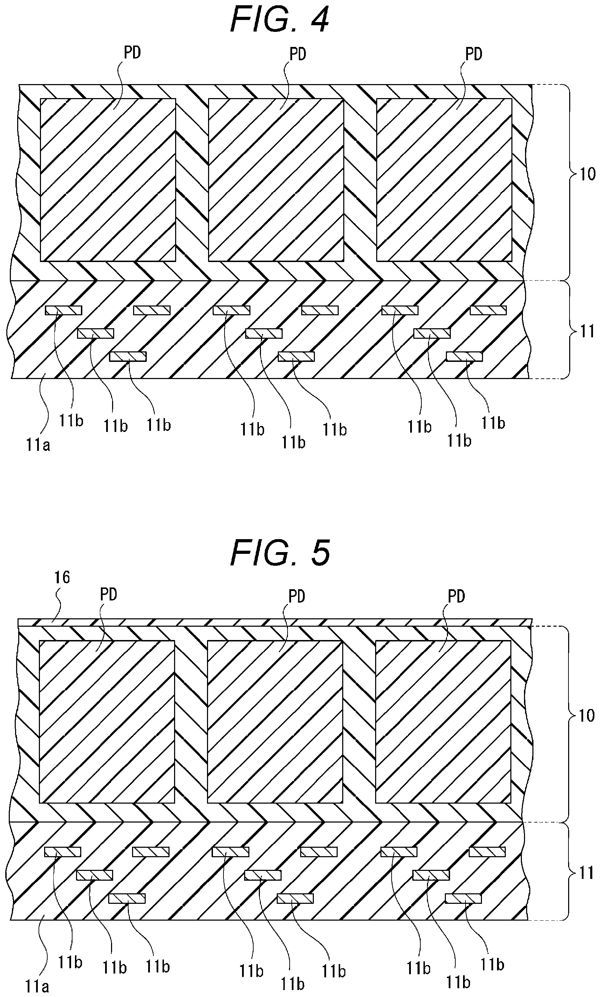

First, a well region, an n-type semiconductor region, and the like are formed in the semiconductor substrate 10, and forms the wiring layer 11 (see Fig. 4).

Next, the insulating layer 16 is formed on the back surface side of the semiconductor substrate 10 (see Fig. 5). The formation of the insulating layer 16 can be implemented by using, for example, chemical vapor deposition (CVD).

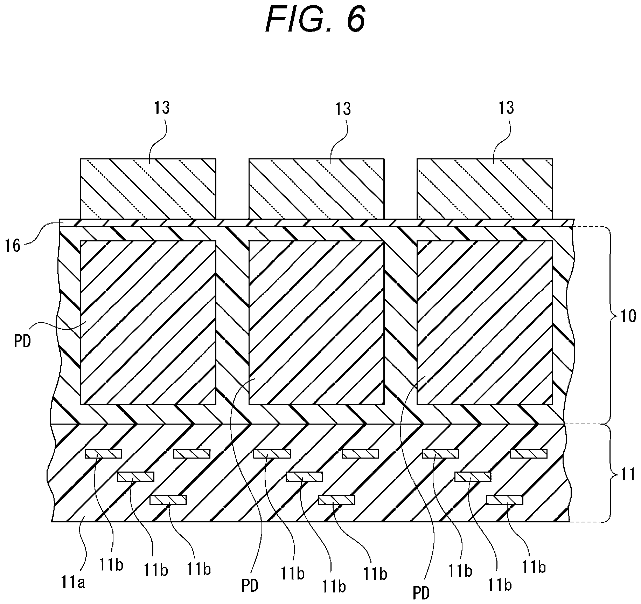

Subsequently, the color filters 13 are arranged on the back surface side of the insulating layer 16 (see Fig. 6). The color filters 13 are arranged adjacent to each other with a gap interposed therebetween.

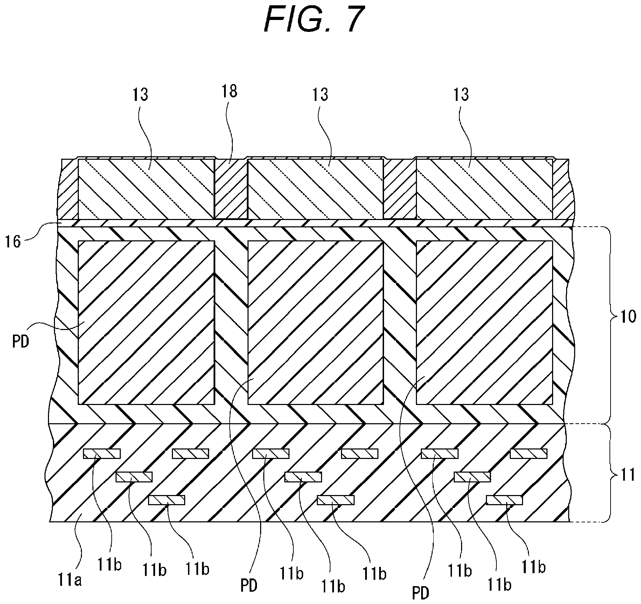

Next, a resist 18 is applied so as to enter the gap between the color filters 13 and cover the back surface of the color filter 13 (see Fig. 7). At this time, the resist 18 is applied such that the height of the surface of the resist 18 in the gap between the color filters 13 coincides with the height of the surface of the color filter 13. Note that, in practice, the resist 18 may be thinly applied also to the surface of the color filter 13, whereby the resist 18 in a gap portion may be formed in a recess.

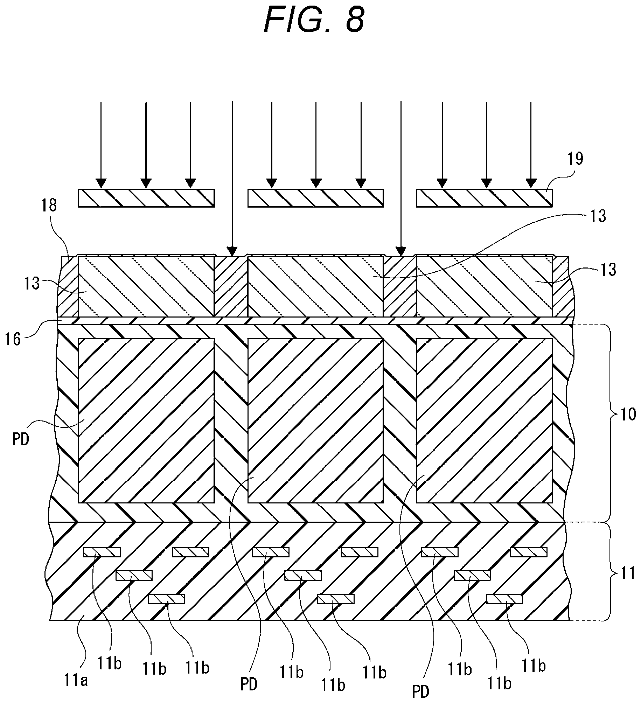

Next, light irradiation is performed only on the resist 18 entering the gap between the color filters 13 by using a reticle 19 in which an opening is formed (see Fig. 8). At this time, since the resist 18 formed as a black organic film has low light transmittance, a curing phenomenon occurs only near the surface irradiated with light.

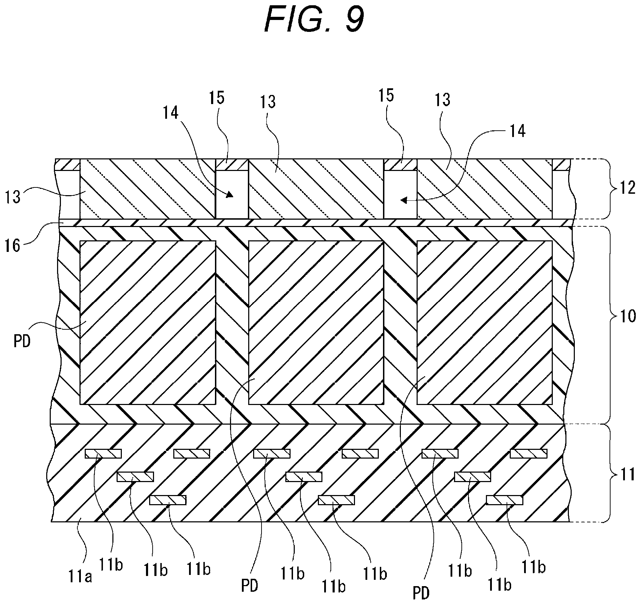

In this state, when the resist 18 uncured is removed, the resist 18 cured remains as the light shielding film 15 (see Fig. 9).

Note that the reticle 19 includes the opening through which light irradiation can be performed also on a pixel region (for example, a dummy pixel region) and a wiring region arranged in an outer peripheral portion of the pixel array unit 2.

As a result, since the light shielding film 15 is also formed in the dummy pixel region and the wiring region, reflection of incident light in a region outside an effective pixel region of the pixel array unit 2 is less likely to occur, and occurrence of flare can be more strongly prevented.

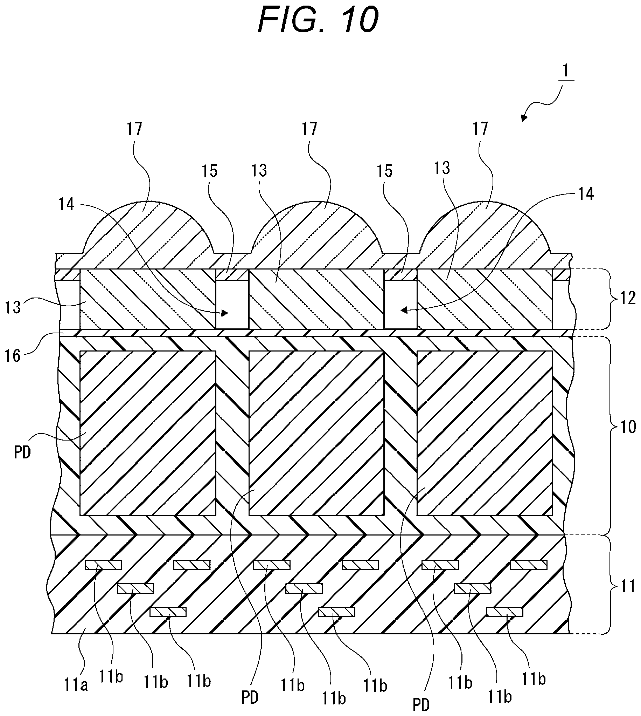

Finally, the on-chip lens 17 is disposed on the back surface of the color filter 13 (see Fig. 10).

### <5. Simulation results>

Simulation results will be described on the effect of suppressing color mixing and the effect of suppressing flare in the solid-state imaging element 1 in the first embodiment described above.

### <5-1. Color mixing suppression effect by light shielding film>

For the solid-state imaging element 1 in the first embodiment and a solid-state imaging element 500 as a conventional example, simulation results of the color mixing suppression effect by the light shielding film 15 were calculated.

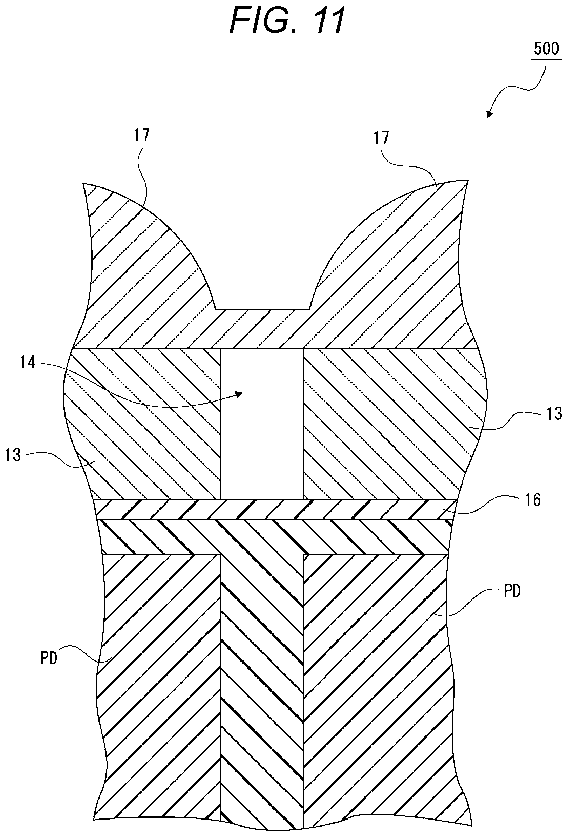

First, a configuration of the solid-state imaging element 500 as the conventional example is illustrated in Fig. 11. In the solid-state imaging element 500, only the void 14 is formed in the gap between the color filters 13. That is, a structure is made in which the light shielding film 15 is removed from the solid-state imaging element 1 in the first embodiment.

Here, the color mixing suppression effect is examined by comparison of how much color mixing occurs due to influence of the transmitted light L6 illustrated in Fig. 3 for the solid-state imaging element 1 and the solid-state imaging element 500.

Note that, in the simulation, three types of visible light (wavelength 450 nm, 530 nm, 600 nm) are used as the incident light L2. Then, the measurement results for three wavelengths are averaged, whereby the color mixing suppression effect in terms of white light is calculated.

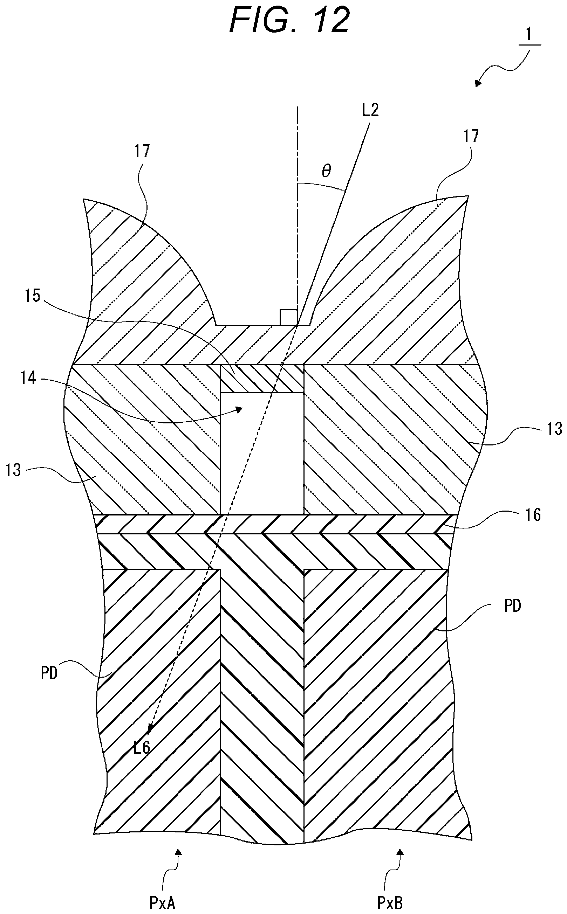

Note that, as illustrated in Fig. 12, the incident light L2 is light incident while inclined by 20 degrees (θ in the figure) with respect to the optical axis.

As a method of calculating a simulation result, an output of a pixel PxA on which the transmitted light L6 is incident when the incident light L2 is incident and an output of an adjacent pixel PxB are used. Specifically, a value obtained by dividing the output of the pixel PxA by the output of the pixel PxB is multiplied by 100, whereby an amount of light of the transmitted light L6 is estimated.

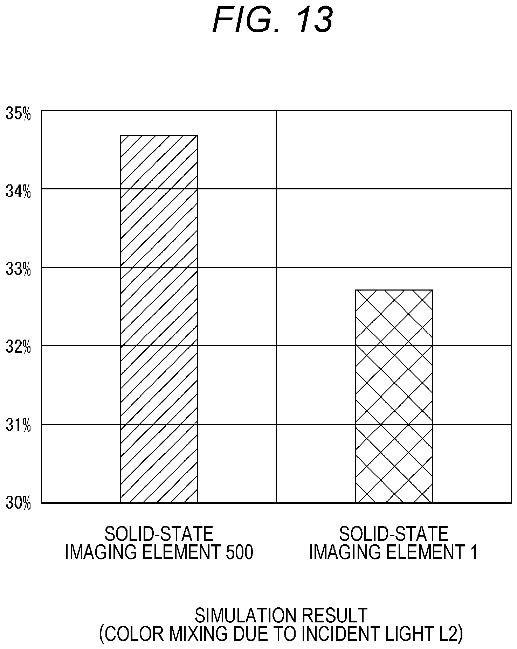

Fig. 13 illustrates the simulation results. As illustrated, a value calculated for the solid-state imaging element 500 not including the light shielding film 15 is slightly less than 35%. On the other hand, a value calculated for the solid-state imaging element 1 having the light shielding film 15 is slightly less than 33%.

Thus, it can be seen that the solid-state imaging element 1 in the present embodiment has a higher effect of suppressing color mixing.

### <5-2. Flare suppression effect by light shielding film>

For the solid-state imaging element 1 in the first embodiment and the solid-state imaging element 500 as the conventional example, simulation results of the flare suppression effect by the light shielding film 15 were calculated.

In this simulation, similarly to the above example, three types of visible light are used as the incident light L2. Then, the effect of suppressing flare by the light shielding film 15 is calculated by conversion into white light.

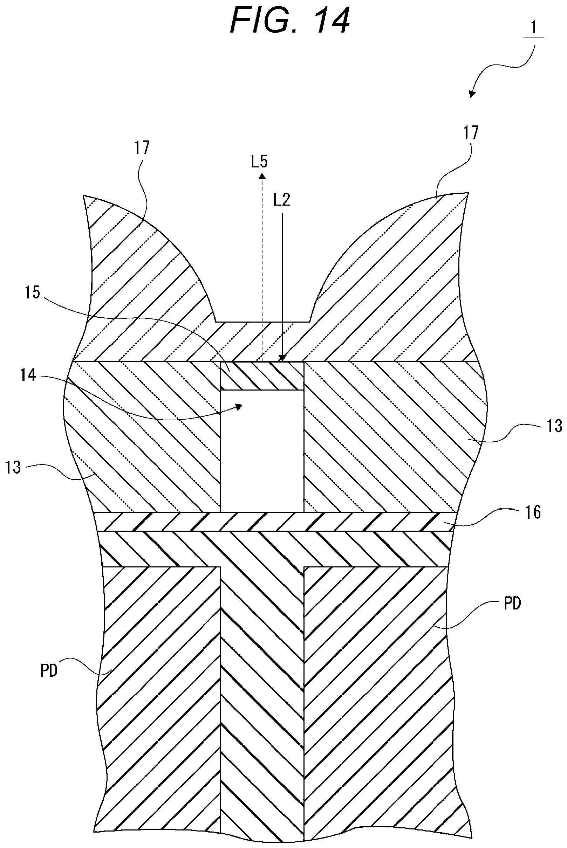

Note that, as illustrated in Fig. 14, the incident light L2 is light parallel to the optical axis.

Furthermore, a value obtained by dividing an amount of light of the reflected light L5 by an amount of light of the incident light L2 is multiplied by 100, whereby a simulation result is obtained.

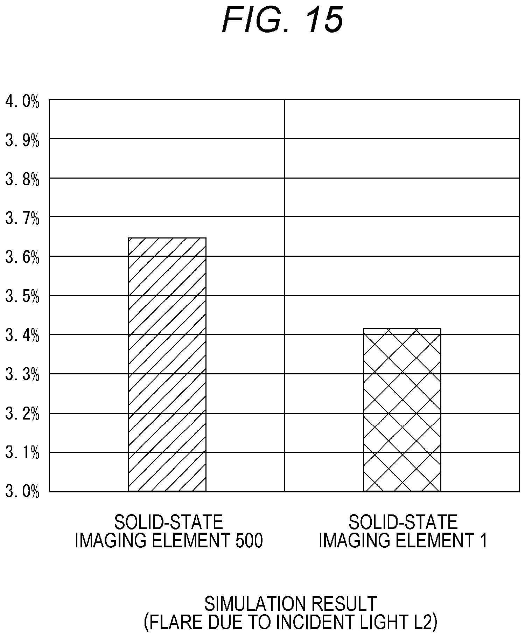

Fig. 15 illustrates the simulation results. As illustrated, a value calculated for the solid-state imaging element 500 not including the light shielding film 15 is greater than or equal to 3.6%. On the other hand, a value calculated for the solid-state imaging element 1 having the light shielding film 15 is slightly greater than 3.4%.

Thus, it can be seen that the solid-state imaging element 1 in the present embodiment has a smaller component of the reflected light L5, and the flare is effectively suppressed.

### <5-3. Color mixing suppression effect and sensitivity improvement effect by void>

For the solid-state imaging element 1 in the first embodiment and a solid-state imaging element 600 as a conventional example, simulation results of the color mixing suppression effect and an effect of improving light receiving sensitivity by the void 14 were calculated.

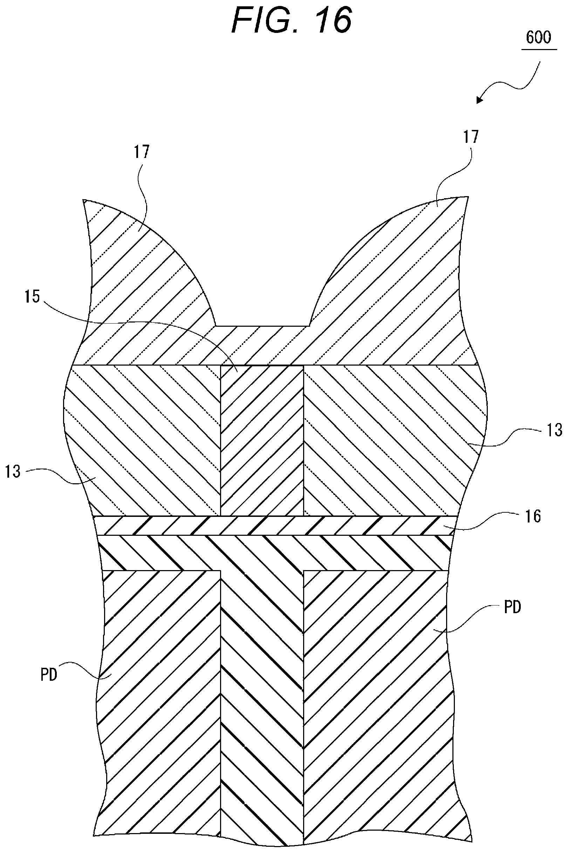

A configuration of the solid-state imaging element 600 is illustrated in Fig. 16. In the solid-state imaging element 500, the gap between the color filters 13 includes only a black negative resist 601.

In this simulation, similarly to the above example, three types of visible light are used as the incident light L1. Then, the color mixing suppression effect and sensitivity improvement effect by the void 14 is calculated by conversion into white light.

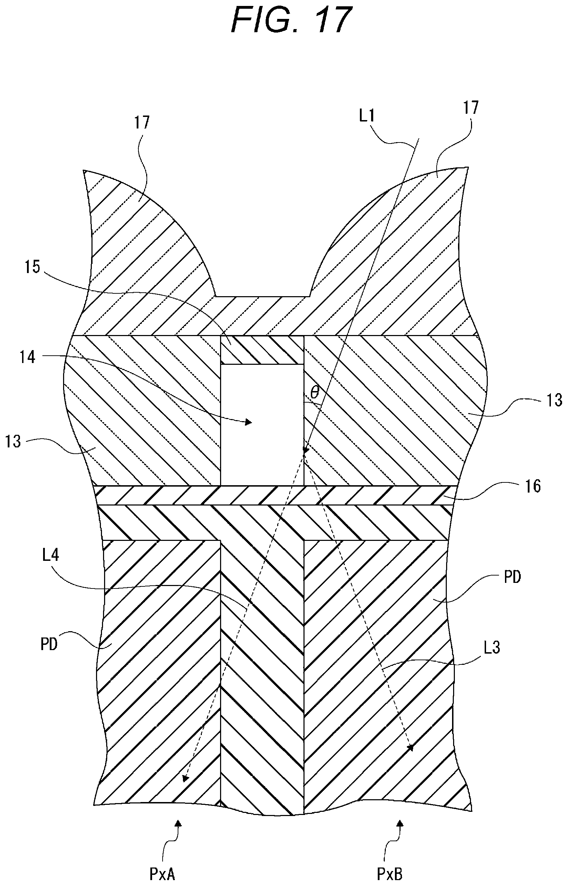

Note that, as illustrated in Fig. 17, the incident light L1 is light incident while inclined by 20 degrees (θ in the figure) with respect to the optical axis.

As a method of calculating a simulation result, the result is obtained by multiplying, by 100, a value obtained by dividing, by an amount of light of the incident light L1, an output of the pixel PxB on which the reflected light L3 reflected by the void 14 is incident when the incident light L1 is incident.

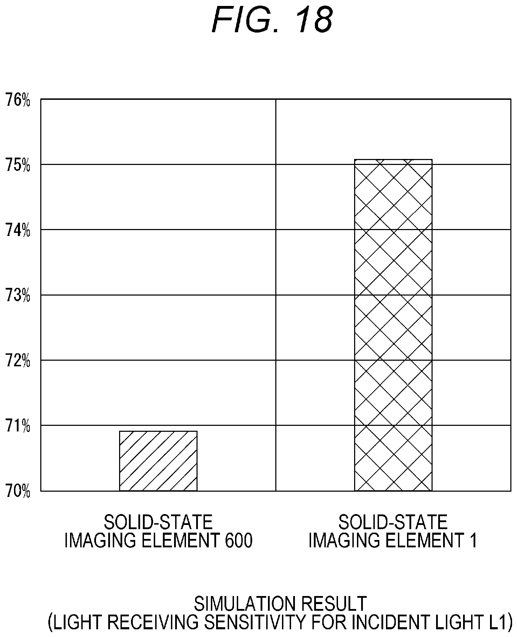

Fig. 18 illustrates the simulation results. As illustrated, a value calculated for the solid-state imaging element 600 in which the void 14 is not formed is slightly less than 71%. On the other hand, a value calculated for the solid-state imaging element 1 in which the void 14 is formed is slightly greater than 75%.

Thus, it can be seen that the solid-state imaging element 1 in the first embodiment has a larger component of the reflected light L3, and utilization efficiency of the incident light L1 is improved. Furthermore, since reflectance is high, a component of the transmitted light L4 to the adjacent pixel PxA is reduced, and a high color mixing suppression effect can be obtained.

### <6. Second embodiment>

In a solid-state imaging element 1A in a second embodiment, at least some of the voids 14 have tapered shapes. The tapered shape here includes both a forward tapered shape and a reverse tapered shape as viewed from the light incident side.

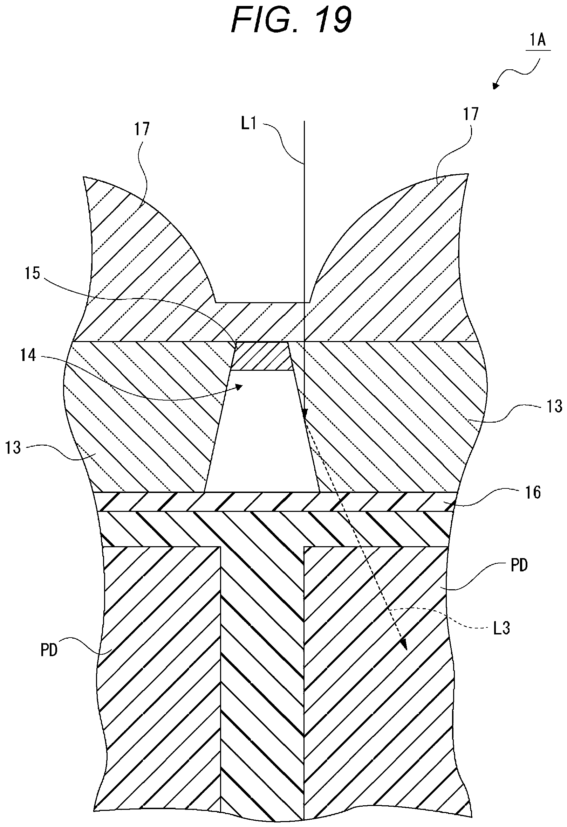

Fig. 19 illustrates an example of the void 14 having a forward tapered shape. The void 14 having a forward tapered shape is configured such that the incident light L1 that is light substantially parallel to the optical axis and is incident on the side surface of the void 14 is reflected toward the photodiode PD that should receive the incident light L1 (reflected light L3).

As a result, the incident light L1 that is less likely to be incident on the photodiode PD can be received by the photodiode PD, and utilization efficiency of light can be improved and light receiving sensitivity can be improved.

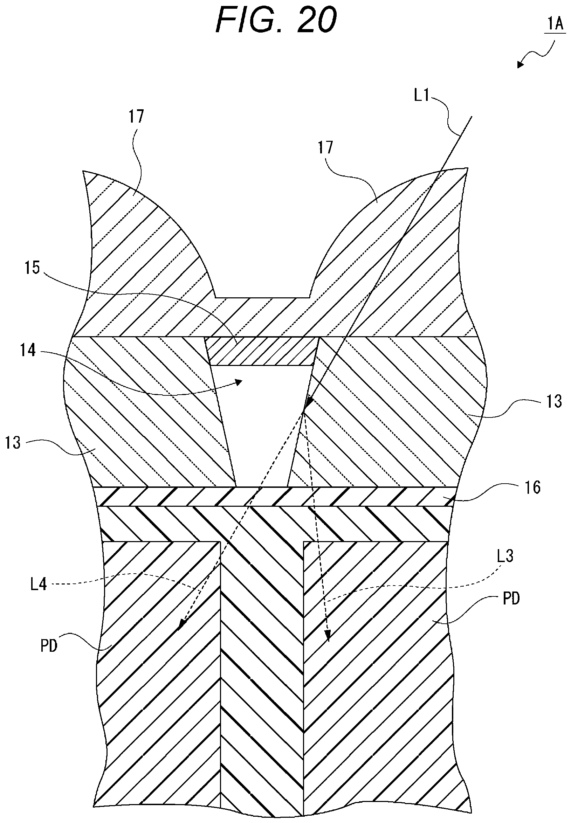

Fig. 20 illustrates an example of the void 14 having a reverse tapered shape. The void 14 having a reverse tapered shape is configured such that the incident light L1 that is light angled with respect to the optical axis and is incident on the side surface of the void 14 is reflected toward the photodiode PD that should receive the incident light L1 (reflected light L3).

As a result, the light incident on the photodiode PD of the adjacent pixel Px as the transmitted light L4 that travels straight without being reflected at the boundary between the color filter 13 and the void 14 can be made incident on the photodiode PD of the pixel Px that should receive the light originally, and color mixing can be suppressed and sensitivity can be improved.

In particular, the void 14 has a reverse tapered shape, whereby it is easy to cause total reflection to occur even when the angle formed with respect to the optical axis is increased, and it is possible to further suppress color mixing and improve sensitivity.

Here, the void 14 having a forward tapered shape and the void 14 having a reverse tapered shape may be arranged in a mixed manner on the same solid-state imaging element 1A.

Furthermore, in that case, the void 14 for the pixels Px located near the optical axis center, that is, the pixels Px arranged near the center of the pixel array (alternatively, the first pixels Px1, the pixels Px arranged at positions where the image height is low) may be formed in a forward tapered shape, and the void 14 for the pixels Px at positions away from the optical axis center, that is, the pixels Px arranged in an outer peripheral portion of the pixel array (alternatively, the second pixels Px2, the pixels Px arranged at positions where the image height is high) may be formed in a reverse tapered shape.

Furthermore, in addition to the pixels Px including the void 14 having a forward tapered shape and the pixels Px including the void 14 having a reverse tapered shape, the pixels Px including the void 14 described in the first embodiment, that is, the void 14 whose side surface is a surface parallel to the optical axis (hereinafter, it is described as the "void 14 having a straight shape") may be arranged in a mixed manner in one solid-state imaging element 1A.

For example, the pixels Px in which the void 14 described in the first embodiment is formed may be arranged between the pixels Px including the void 14 having a forward tapered shape and the pixels Px in which the void 14 having a reverse tapered shape is formed.

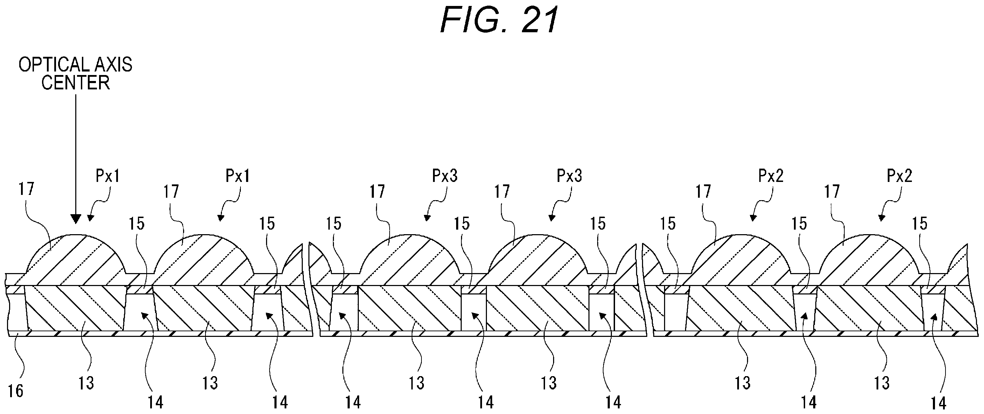

An example is illustrated in Fig. 21.

For the pixels Px (first pixels Px1) arranged at positions where the image height is low, light substantially parallel to the optical axis is incident; however, the void 14 having a forward tapered shape is formed, whereby light incident near the boundary between the void 14 and the color filter 13 can be appropriately guided to the photodiode PD. As a result, the light receiving sensitivity of the pixel Px can be improved. Furthermore, in particular, since the incident light can be reflected toward the substantially center of the photodiode PD by the void 14 having a forward tapered shape, the utilization efficiency of light can be further improved.

Then, in the pixels Px (third pixels Px3) arranged at positions where the image height is medium, incident light substantially parallel to the optical axis is not incident, and incident light slightly angled with respect to the optical axis is incident. The void 14 having a straight shape is provided with respect to such incident light, whereby the light reflected at the boundary with the color filter 13 is easily condensed at the substantially center of the photodiode PD, so that sensitivity can be suitably improved.

Moreover, for the pixels Px (second pixels Px2) arranged at positions where the image height is high, oblique incident light (incident light with a shallow incident angle) with a large angle with respect to the optical axis is incident; however, the void 14 having a reverse tapered shape is formed, whereby light incident on the side surface of the void 14 is easily reflected to the original pixel Px. Thus, the light receiving sensitivity of the pixel Px can be improved and color mixing can be prevented.

As described above, the void 14 having a reverse tapered shape is disposed at a position farther from an image height center than the void 14 having a forward tapered shape, whereby the void 14 having a shape that easily reflects incident light to the original pixel Px is formed as appropriate according to the arrangement position of the pixel Px. Thus, it is possible to improve the light receiving sensitivity and prevent the color mixing.

Note that a shape of the void 14 arranged at the boundary between the first pixel Px1 and the third pixel Px3 is such that one side is a forward tapered shape and the other side is a straight shape.

Furthermore, a shape of the void 14 arranged at the boundary between the third pixel Px3 and the second pixel Px2 is such that one side is a straight shape and the other side is a reverse tapered shape.

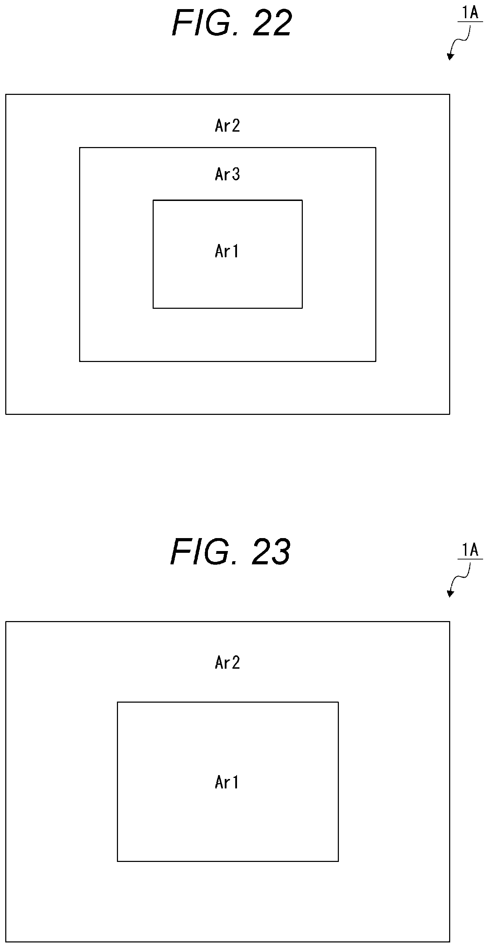

Arrangement examples of the first pixels Px1, the second pixels Px2, and the third pixels Px3 are illustrated in Figs. 22, 23, and 24.

A region where the first pixels Px1 are arranged is referred to as a first area Ar1, a region where the second pixels Px2 are arranged is referred to as a second area Ar2, and a region where the third pixels Px3 are arranged is referred to as a third area Ar3.

The example illustrated in Fig. 22 is an example in which the first area Ar1, the third area Ar3, and the second area Ar2 are arranged in order from a side closer to the optical axis center, and is the same as the arrangement example illustrated in Fig. 21.

With this arrangement, an appropriate void 14 is provided according to the angle of the incident light with respect to the optical axis, and color mixing prevention and sensitivity improvement are achieved.

The example illustrated in Fig. 23 is an example in which the first area Ar1 and the second area Ar2 are arranged in order from the side closer to the optical axis center.

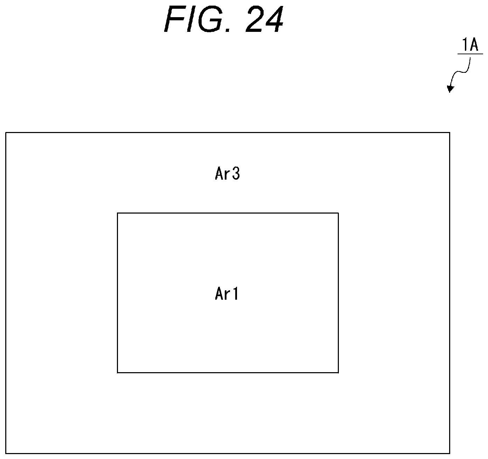

Furthermore, the example illustrated in Fig. 24 is an example in which the first area Ar1 and the third area Ar3 are arranged in order from the side closer to the optical axis center.

As illustrated in Fig. 23 or Fig. 24, types of shapes of the voids 14 are narrowed down to two types, whereby a degree of difficulty of manufacturing can be lowered, and the manufacturing cost can be suppressed and a yield can be improved.

Note that the first area Ar1, the second area Ar2, and the third area Ar3 in Figs. 22, 23, and 24 are rectangular regions, but are not limited thereto, and may be substantially circular regions or substantially elliptical regions.

Note that, in a case where the void 14 having a straight shape is not disposed as illustrated in Fig. 23, a cross-sectional shape of the void 14 at the boundary between the first area Ar1 and the second area Ar2 is a substantially parallelogram.

Note that the tapered shape (including the straight shape) of the void 14 may be changed for each type of the color filter 13. This is because total reflection is less likely to occur at the boundary between the void 14 and the color filter 13 as the wavelength of the incident light is longer.

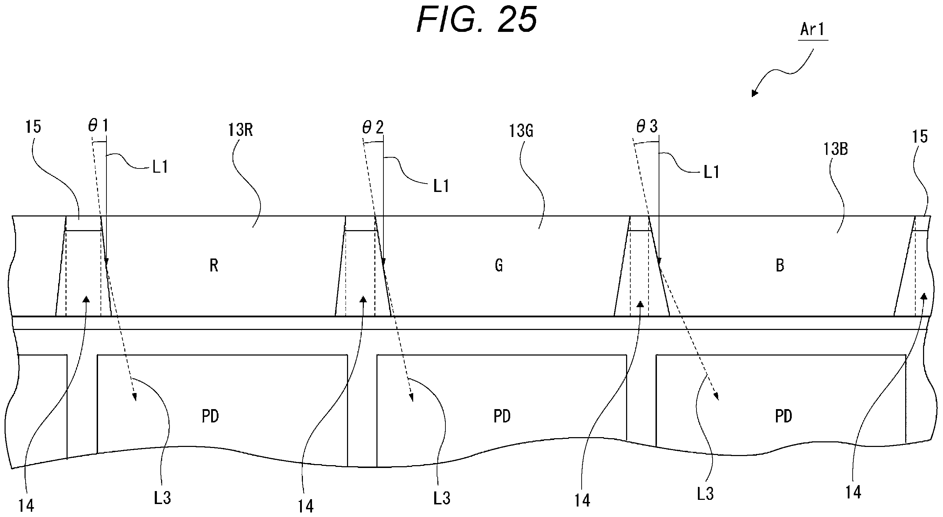

Fig. 25 specifically illustrates an example of the shapes of the void 14 provided corresponding to the color filters 13R, 13G, and 13B arranged in the first area Ar1. Note that, although Fig. 25 illustrates that the color filter 13R, the color filter 13G, and the color filter 13B are arranged in the same pixel row for convenience of description, the solid-state imaging element 1A may include only a pixel row in which the color filter 13R and the color filter 13G are arranged and a pixel row in which the color filter 13G and the color filter 13B are arranged.

An angle formed by the optical axis direction and a boundary between the color filter 13R and the void 14 is θ1. Similarly, an angle formed by the optical axis direction and a boundary between the color filter 13G and the void 14 is θ2, and an angle formed by the optical axis direction and a boundary between the color filter 13B and the void 14 is θ3.

At this time, the tapered shape of the void 14 is formed so that θ1 < θ2 < θ3 holds. That is, an angle of the tapered shape formed as the boundary between the color filter 13B and the void 14 is the largest.

As a result, an incident angle when the incident light L1 being light parallel to the optical axis is incident on the side surface of the void 14 is larger with respect to the color filter 13G than with respect to the color filter 13R, and is larger with respect to the color filter 13B than with respect to the color filter 13G.

Thus, since the incident light L1 is reflected at an appropriate angle according to the wavelength of light, the light receiving sensitivity can be more appropriately improved.

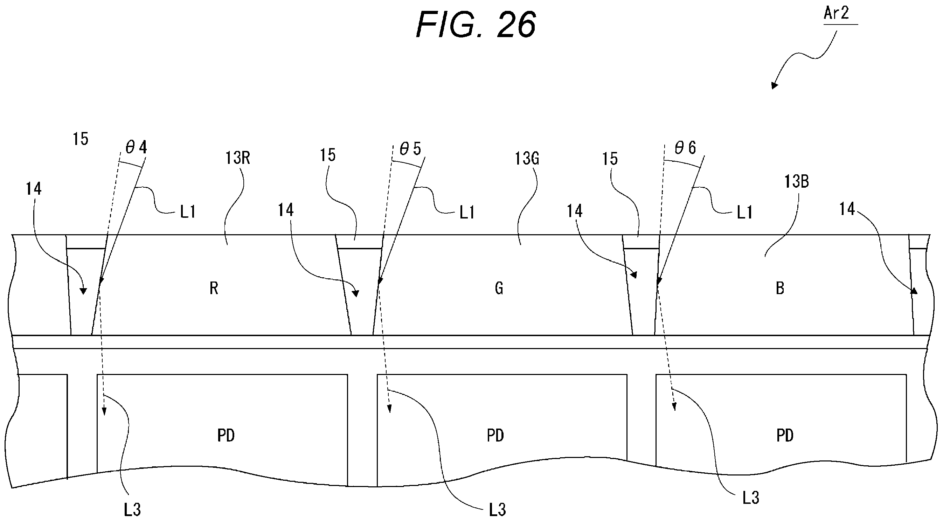

Furthermore, Fig. 26 illustrates an example of the shapes of the void 14 provided corresponding to the color filters 13R, 13G, and 13B arranged in the second area Ar2.

Note that the incident light L1 is light inclined by 20 degrees with respect to the optical axis.

An angle formed by the incident light L1 and the boundary between the color filter 13R and the void 14 is θ4. Similarly, an angle formed by the incident light L1 and the boundary between the color filter 13G and the void 14 is θ5, and an angle formed by the incident light L1 and the boundary between the color filter 13B and the void 14 is θ6.

At this time, the tapered shape of the void 14 is formed so that θ4 < θ5 < θ6 holds. That is, an angle of the tapered shape formed as the boundary between the color filter 13R and the void 14 is the largest.

As a result, an incident angle when the incident light L1 obliquely angled with respect to the optical axis is incident on the side surface of the void 14 is larger with respect to the color filter 13G than with respect to the color filter 13R, and is larger with respect to the color filter 13B than with respect to the color filter 13G.

Thus, since the incident light L1 is reflected at an appropriate angle according to the wavelength of light, the light receiving sensitivity can be more appropriately improved.

Note that the tapered shape of the void 14 may be a shape in which a corner portion is a straight line as illustrated so far, but may be a shape in which the corner portion is rounded in consideration of ease of manufacturing.

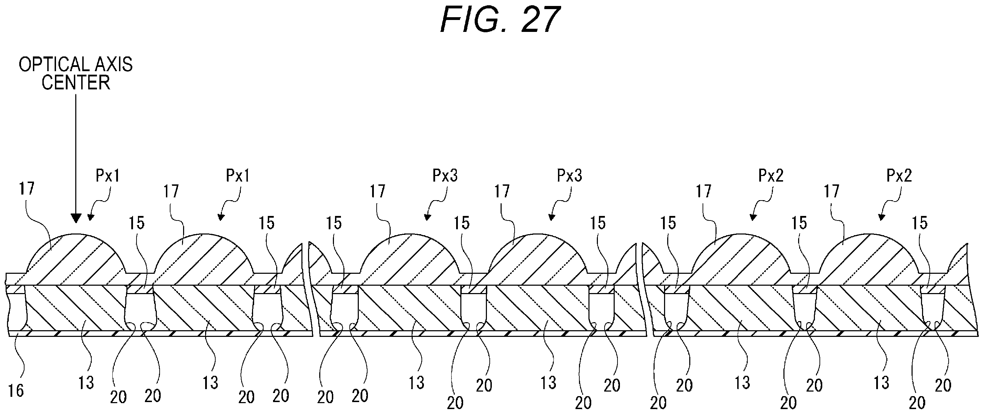

Fig. 27 illustrates a specific configuration. As illustrated, a corner portion 20 of the void 14, specifically, the corner portion 20 of a boundary portion of the insulating layer 16 in the void 14 has a rounded shape.

The corner portion 20 is allowed to have a rounded shape, whereby processing for forming the corner portion 20 at an acute angle is unnecessary, and thus, it is possible to manufacture the solid-state imaging element 1A without increasing the number of steps for forming the void 14. Furthermore, the degree of difficulty of manufacturing the solid-state imaging element 1A can be reduced, and cost reduction of manufacturing apparatuses, or the like can be achieved.

Note that light used to form the light shielding film 15 and the color filter 13 is, for example, i-line (spectral line of mercury having a wavelength of 365 nm). At this time, since the color filter 13R has a high i-line transmittance, the resist 18 near the boundary between the void 14 and the insulating layer 16 is cured in a wider range than that in the other color filters 13. Thus, the corner portion 20 of the void 14 adjacent to the color filter 13R may have a more rounded shape than the corner portion 20 of the void 14 adjacent to the other color filters 13G and 13B.

As described above, the shape of the corner portion 20 according to the characteristics of the color filter 13 is allowed, whereby the manufacturing cost can be reduced.

### <7. Third embodiment>

In a solid-state imaging element 1B according to a third embodiment, a metal film 21 is formed between the void 14 and the insulating layer 16.

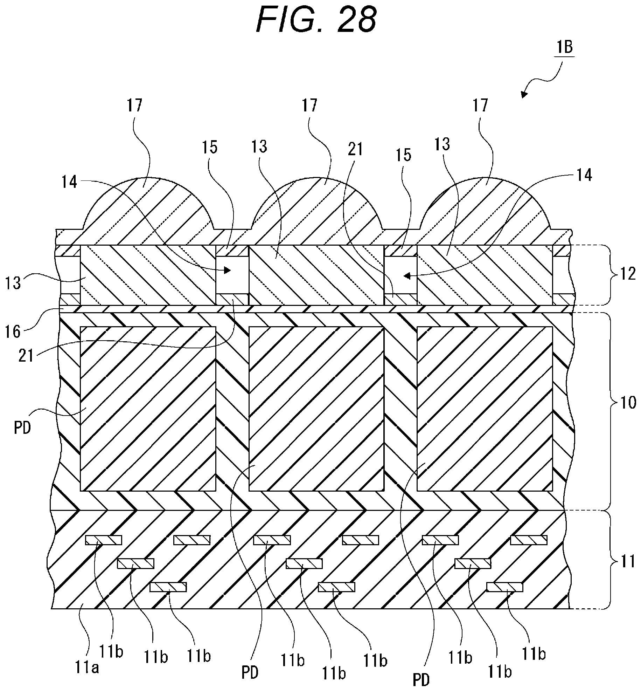

A specific structure is illustrated in Fig. 28.

The solid-state imaging element 1B includes the semiconductor substrate 10, the wiring layer 11, the filter layer 12, and the on-chip lens 17 that are stacked, and the insulating layer 16 is formed between the semiconductor substrate 10 and the filter layer 12.

Furthermore, the color filters 13 are arranged in the filter layer 12 to be separated from each other, and a space between the color filters 13 includes the void 14, the light shielding film 15 provided on the light incident side of the void 14, and the metal film 21 provided on the opposite side from the light shielding film 15 with respect to the void 14.

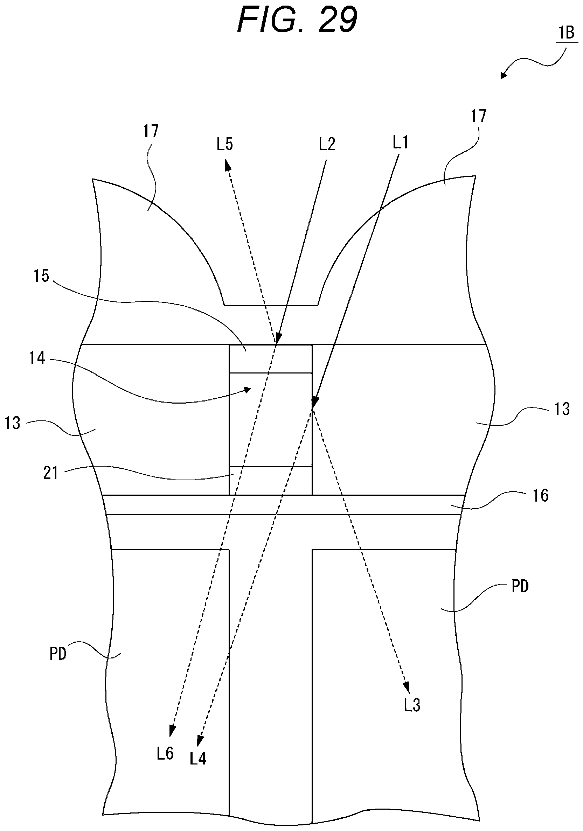

A function of the metal film 21 will be described with reference to Fig. 29. For the solid-state imaging element 1B, the incident light L1 incident on the side surface of the void 14 and the incident light L2 incident on the light shielding film 15 are considered.

The incident light L1 is totally reflected by the side surface of the void 14, thereby being incident on the photodiode PD of the pixel Px that should receive the incident light L1. However, a part of the incident light L1 may travel straight toward the photodiode PD of the adjacent pixel Px. This is because the boundary between the void 14 and the color filter 13 may not be formed in a perfect straight line.

In such a case, the metal film 21 plays a role of absorbing the incident light L1 traveling straight. As a result, the incident light L1 is prevented from being received by the adjacent pixel Px of the pixel Px that should receive the incident light L1 originally, and color mixing can be further suppressed.

Next, the incident light L2 is absorbed by the light shielding film 15, whereby a component of the reflected light L5 is reduced and occurrence of flare is suppressed. However, a part of the incident light L2 may be received by the photodiode PD without passing through the color filter 13 by traveling straight through the light shielding film 15. This is because thickness of the light shielding film 15 may not be completely uniform.

In such a case, the metal film 21 plays a role of absorbing the incident light L2 traveling straight. As a result, the incident light L2 is prevented from being received by the photodiode PD, and color mixing and noise components can be more effectively suppressed.

The metal film 21 includes, for example, tungsten (W) or the like. Furthermore, the metal film 21 may have a multilayer structure, and in that case, tungsten may be disposed on the void 14 side, and titanium (Ti), titanium nitride (TiN), or the like may be disposed on the insulating layer 16 side. Furthermore, a single layer of titanium or titanium nitride may be included.

The layer of titanium or titanium nitride is, for example, a layer provided for improving adhesion with the insulating layer 16.

Note that, in a case where the metal film 21 includes a single layer of tungsten, titanium, or titanium nitride, manufacturing steps and costs can be reduced.

A method of manufacturing the solid-state imaging element 1B will be described with reference to the accompanying drawings. Note that, since steps up to a middle step are steps similar to those for the solid-state imaging element 1 in the first embodiment, description thereof is omitted.

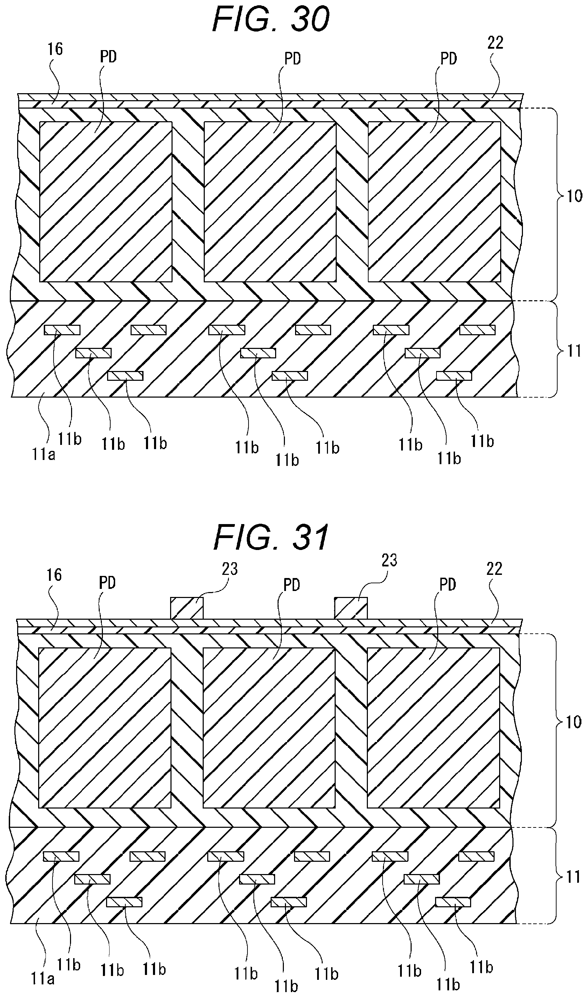

After the insulating layer 16 is formed on the back surface side of the semiconductor substrate 10 (see Fig. 5), before the color filters 13 are arranged, a metal layer 22 being a film-like layer of metal is formed on the surface of the insulating layer 16 (see Fig. 30) .

Next, on the surface of the metal layer 22, a resist 23 is applied to a portion where the metal film 21 is to be disposed, that is, a portion other than arrangement regions for the color filters 13 (see Fig. 31).

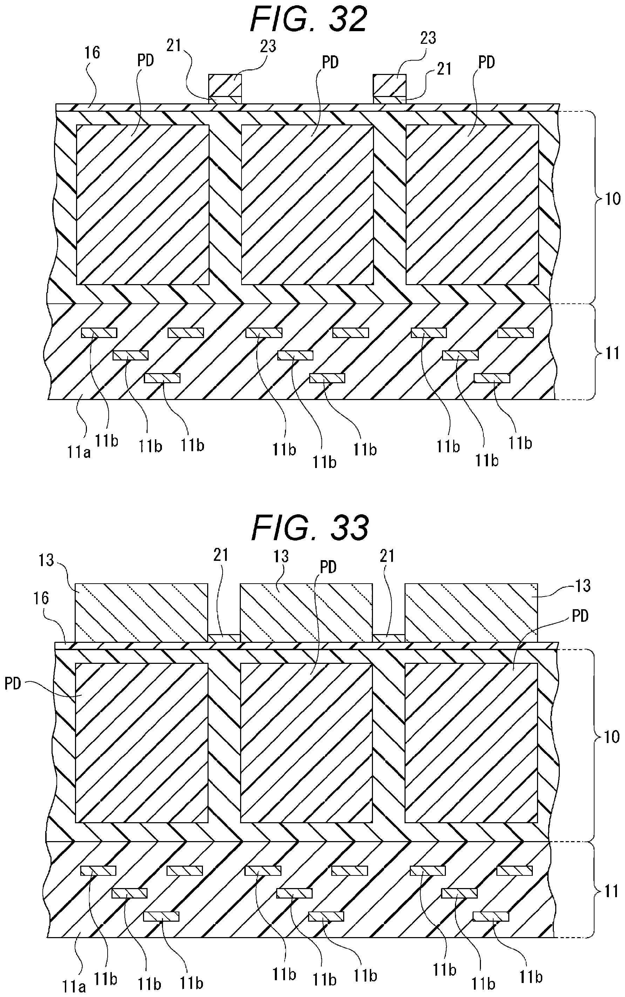

Subsequently, the resist 23 is used as a mask, whereby etching is performed for the metal film 21 (see Fig. 32). The metal layer 22 in regions where the color filters 13 are to be arranged are removed by dry etching, for example, and only a portion formed as the metal film 21 can be left.

Subsequently, the color filters 13 are arranged at portions from which the metal layer 22 is removed (see Fig. 33). The subsequent steps are similar to the steps illustrated in respective Figs. 7 to 10 except that the metal film 21 is formed, and thus the description thereof is omitted.

### <8. Fourth embodiment>

In a solid-state imaging element 1C in a fourth embodiment, a light shielding film 15C is formed so as to extend to a layer in which the on-chip lens 17 is formed.

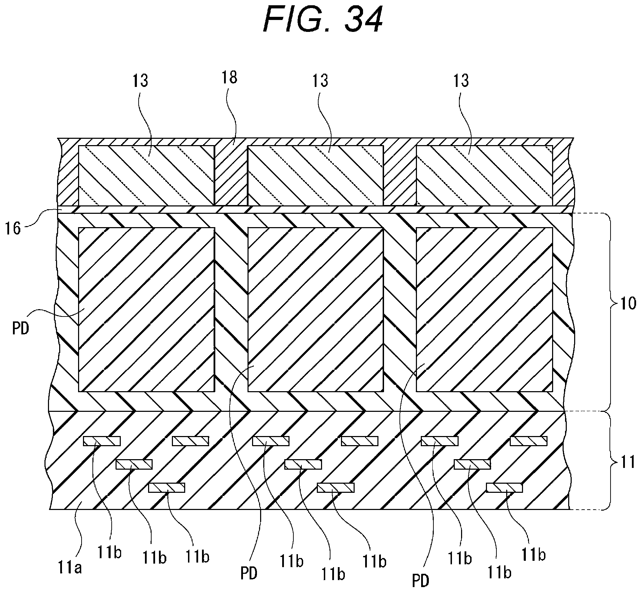

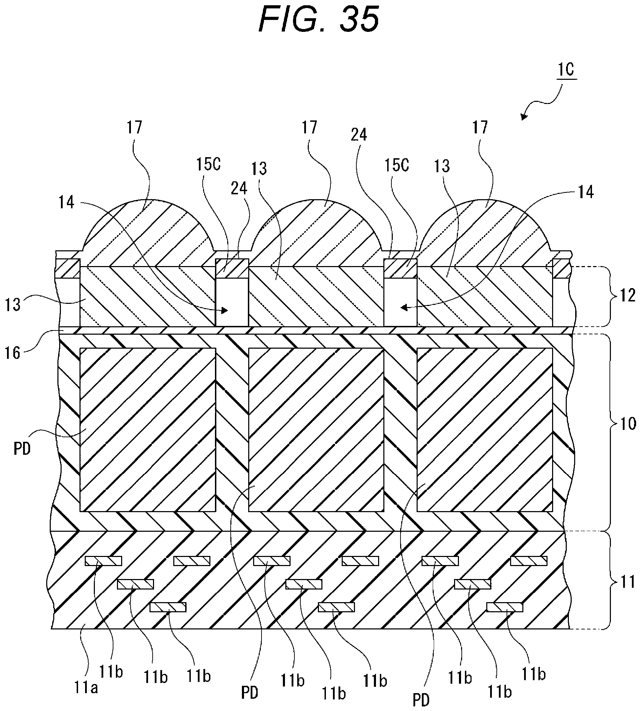

A specific configuration will be described with reference to Figs. 34 and 35.

The light shielding film 15C has a shape in which an end portion on the light incident side extends not to a surface position of the color filter 13 but to the light incident side. That is, an upper end portion 24 of the light shielding film 15C is disposed on the light incident side from a boundary between the on-chip lens 17 and the color filter 13.

A method of manufacturing the solid-state imaging element 1C will be described. Note that the steps from Figs. 4 to 6 are similar to those in the above-described example, and thus description thereof is omitted.

Subsequently, as illustrated in Fig. 34, the resist 18 is applied so that the upper end portion 24 of the light shielding film 15C extends to the light incident side from the end portion on the light incident side of the color filter 13.

Next, the reticle 19 is used to cure a part of the resist 18, and the light shielding film 15C is formed (see Fig. 8). Thereafter, the light shielding film 15 is not left so as to be in the surface position with respect to the color filter 13 as illustrated in Fig. 9, but the light shielding film 15C is left so as to protrude to the light incident side from the color filter 13.

In this way, the light shielding film 15C illustrated in Fig. 35 is formed.

The light shielding film 15C is formed to extend to the on-chip lens 17 side from the color filter 13, whereby a color mixing suppression effect between the on-chip lenses 17 can be obtained, so that light incident on the photodiode PD can be made more monochromatic light, and a high color mixing suppression effect can be obtained as a whole.

### <9. Application to camera>

The above-described solid-state imaging element 1 (1A, 1B, 1C) is used for various apparatuses. As an example, an imaging apparatus 100 including the solid-state imaging element 1 will be described.

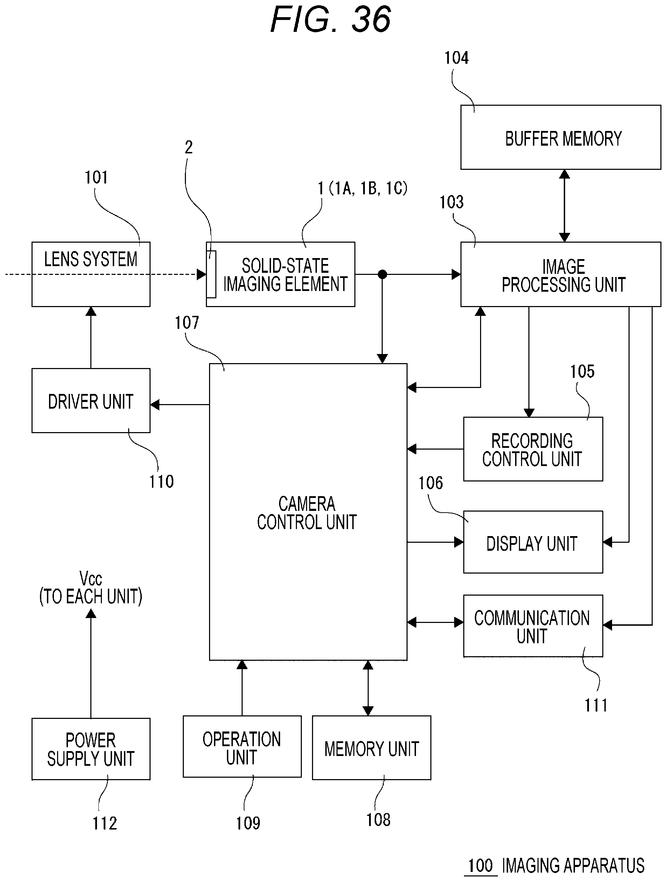

A functional configuration of the imaging apparatus 100 will be described with reference to Fig. 36.

The imaging apparatus 100 includes a lens system 101, the solid-state imaging element 1 (1A, 1B, 1C), an image processing unit 103, a buffer memory 104, a recording control unit 105, a display unit 106, a camera control unit 107, a memory unit 108, an operation unit 109, a driver unit 110, a communication unit 111, and a power supply unit 112.

The lens system 101 includes various lenses such as an incident end lens, a zoom lens, a focus lens, and a condenser lens, an iris mechanism that performs exposure control by adjusting the lenses, an aperture amount by an iris (diaphragm), and the like so that sensing is performed in a state where signal charges are not saturated and are within a dynamic range, and a shutter unit such as a focal plane shutter.

The lens system 101 is an optical system element on which light is incident, and is disposed as appropriate in a lens barrel (not illustrated) or a housing of the imaging apparatus 100.

The solid-state imaging element 1 (1A, 1B, 1C) includes the pixel array unit 2. The solid-state imaging element 1 receives light incident from the lens system 101 and outputs a pixel signal according to an amount of received light.

The solid-state imaging element 1 includes the signal processing unit 7 that generates a captured image signal as digital data on the basis of a pixel signal obtained from the pixel array unit 2 (see Fig. 1). The captured image signal is output to the image processing unit 103 and the camera control unit 107.

The image processing unit 103 is configured as an image processing processor by, for example, a digital signal processor (DSP) or the like.

The image processing unit 103 performs various types of signal processing on a digital signal (captured image signal), that is, RAW image data, output from the solid-state imaging element 1.

For example, the image processing unit 103 performs lens correction, noise reduction, synchronization processing, YC generation processing, color reproduction/sharpness processing, and the like.

In the synchronization processing, color separation processing is performed in which image data for each pixel is made to have all color components of red (R), green (G), and blue (B). For example, in a case of an imaging element using a Bayer color filter, demosaicing processing is performed as the color separation processing.

In the YC generation processing, a luminance (Y) signal and a color (C) signal are generated (separated) from the image data of R, G, and B.

In the color reproduction/sharpness processing, processing is performed of adjusting gradation, saturation, tone, contrast, and the like, as so-called image creation.

The image processing unit 103 performs the above-described signal processing generally called development processing to generate image data in a predetermined format.

In this case, resolution conversion or file formation processing may be performed. In the file formation processing, image data is subjected to, for example, compression encoding for recording or communication, formatting, and generation or addition of metadata to generate a file for recording or communication.

For example, an image file is generated as a still image file in a format such as Joint Photographic Experts Group (JPEG), Tagged Image File Format (TIFF), Graphics Interchange Format (GIF), or High Efficiency Image File Format (HEIF). Furthermore, it is also conceivable to generate an image file as, for example, an MP4 format used for recording a moving image and audio conforming to MPEG-4.

Note that the image processing unit 103 may generate an image file of RAW image data not subjected to the development processing.

The buffer memory 104 includes a dynamic random access memory (D-RAM), for example. The buffer memory 104 is used for temporary storage of image data in the course of the development processing and the like described above performed by the image processing unit 103.

Note that the buffer memory 104 may be a memory chip separate from the image processing unit 103, or may be configured as an internal memory area such as a DSP constituting the image processing unit 103.

The recording control unit 105 performs recording and reproduction on a recording medium including a nonvolatile memory, for example. The recording control unit 105 performs processing of recording an image file such as moving image data or still image data on the recording medium, for example.

Various actual forms of the recording control unit 105 can be considered. For example, the recording control unit 105 may include a flash memory built in the imaging apparatus 100 and a write circuit and a read circuit thereof. Furthermore, the recording control unit 105 may be in a form of a card recording/reproducing unit that performs recording/reproducing access to a recording medium detachable from the imaging apparatus 100, for example, a memory card (portable flash memory or the like). Furthermore, the recording control unit 105 may be implemented as a hard disk drive (HDD) or the like as a form built in the imaging apparatus 100.

The display unit 106 is a display unit that performs various displays for a user, and is a backside monitor provided on a backside of a camera housing or an electric viewfinder (EVF) monitor provided on the upper part of the housing.

The display unit 106 executes various displays on a display screen on the basis of an instruction from the camera control unit 107. For example, the display unit 106 displays a reproduced image of image data read from the recording medium in the recording control unit 105.

Furthermore, there is a case where image data of a captured image (captured image data) whose resolution has been converted for a display by the image processing unit 103 is supplied to the display unit 106, and the display unit 106 performs the display on the basis of the image data of the captured image according to an instruction from the camera control unit 107. As a result, a so-called through image (subject monitoring image) is displayed that is a captured image during composition confirmation or during moving image recording.

Furthermore, the display unit 106 executes displays of various operation menus, icons, messages, and the like, that is, graphical user interfaces (GUIs) on the screen on the basis of an instruction from the camera control unit 107.

The camera control unit 107 includes a microcomputer including a central processing unit (CPU).

The memory unit 108 stores data and the like used for processing by the camera control unit 107. As the memory unit 108 illustrated, for example, a read only memory (ROM), a random access memory (RAM), a flash memory, and the like are comprehensively illustrated.

The memory unit 108 may be a memory area built in a microcomputer chip as the camera control unit 107 or may be a separate memory chip.

The camera control unit 107 controls the entire imaging apparatus 100 by executing a program stored in the ROM, the flash memory, or the like of the memory unit 108.

For example, the camera control unit 107 controls operations of the respective unit necessary for control of a shutter speed of the solid-state imaging element 1, instructions for the various types of signal processing in the image processing unit 103, an imaging operation or an image recording operation according to an operation of the user, a reproduction operation of a recorded image file, and control of the zoom lens, the focus lens, and the iris mechanism as the lens system 101. Furthermore, the camera control unit 107 performs processing of detecting operation information by the operation unit 109 as a user interface operation and display control of each display unit such as the backside monitor and the EVF monitor 5a. Furthermore, the camera control unit 107 also performs control related to a communication operation with an external device by the communication unit 111.

The RAM in the memory unit 108 is used for temporary storage of data, a program, and the like as a work area during various types of data processing by the CPU of the camera control unit 107.

The ROM and the flash memory (nonvolatile memory) in the memory unit 108 are used to store an operating system (OS) for the CPU to control each unit and a content file such as an image file. Furthermore, the ROM and the flash memory in the memory unit 108 are used to store application programs, firmware, various types of setting information, and the like for various operations of the camera control unit 107 and the image processing unit 103.

The operation unit 109 includes a manipulating element provided at each place of the camera housing, the backside monitor equipped with a touch panel function, and the like.

The driver unit 110 is provided with a motor driver for a zoom lens drive motor, a motor driver for a focus lens drive motor, a motor driver for an iris mechanism motor, and the like, for example.

These motor drivers each apply a drive current to a corresponding driver according to an instruction from the camera control unit 107 to execute movement of the focus lens and the zoom lens, opening and closing of diaphragm blades of the iris mechanism, and the like.

The communication unit 111 is a communication module for performing wired communication or wireless communication.

The power supply unit 112 generates a power supply voltage (Vcc) necessary for each unit from, for example, a battery housed inside the camera housing, and supplies the power supply voltage as an operating voltage.

In a state where the lens barrel is mounted to the imaging apparatus 100, the power supply voltage Vcc by the power supply unit 112 is also supplied to a circuit inside the lens barrel.

Note that the power supply unit 112 may be formed with a circuit that charges the battery or a circuit that generates the power supply voltage Vcc, using a DC voltage converted and input by an AC adapter connected to a commercial AC power supply as a power supply.

In the imaging apparatus 100 including the solid-state imaging element 1, the sensitivity of the imaging apparatus 100 can be improved, and image data (image file or the like) in which noise is suppressed can be generated.

### <10. Modifications>

The shape of the void 14 described in the second embodiment can be suitably applied to the solid-state imaging element 1 (1B, 1C) described in the first, third, and fourth embodiments.

Similarly, the configuration including the metal film 21 described in the third embodiment and the configuration including the light shielding film 15C described in the fourth embodiment can also be suitably applied to the solid-state imaging element (1, 1A, 1B, 1C) of the other embodiments.

In the above-described examples, the above-described color filter 13 and the structure therebetween (the structures of the void 14 and the light shielding film 15) can also be applied to an imaging element in which a separation portion is formed between a photodiode PD of a certain pixel Px and a photodiode PD of its adjacent pixel Px.

In the above-described example, the back-illuminated solid-state imaging element 1 has been described as an example, but the present technology is also applicable to a front-illuminated solid-state imaging element.

### <11. Summary>

As described above, the solid-state imaging element 1 (1A, 1B, 1C) includes the photoelectric conversion unit (photodiode PD) that performs photoelectric conversion, and the color filter 13 (13R, 13G, 13B) that is formed on the light incident side of the photoelectric conversion unit and selectively transmits light received by the photoelectric conversion unit, in which the void 14 and the light shielding film 15 (15C) on the light incident side of the void 14 are formed between the color filters 13.

The void 14 is formed between the color filters 13, whereby total reflection occurs for light incident from the side surface of the void 14. Then, due to the light shielding film 15 above the void 14, the light incident from above on the boundary portion of the color filter 13 is blocked by the light shielding film 15.

Thus, it is possible to obtain both effects of improving the sensitivity of the pixel Px due to the fact that light incident on the pixel Px is reflected to the original pixel Px by the void 14 without being incident on the adjacent pixel Px, and suppressing color mixing by the light shielding film 15.

As described with reference to Fig. 2 and the like, the light shielding film 15 (15C) in the solid-state imaging element 1 (1A, 1B, 1C) may include the black negative resist (resist 18).

As a result, light shielding can be suitably performed, and an effect of suppressing color mixing can be enhanced. Furthermore, reflection of incident light by the light shielding film 15 is suppressed, whereby an effect of suppressing occurrence of flare can be obtained.

As described with reference to Fig. 2 and the like, the light shielding film 15 (15C) in the solid-state imaging element 1 (1A, 1B, 1C) may include a negative resist (resist 18) having a light shielding property or wavelength selectivity.

That is, the light shielding film 15 may be a negative resist having wavelength selectivity in addition to a negative resist having a light shielding property. For example, in a case where the light source emits light other than blue light, a negative resist that allows only blue light to pass through is included in the light shielding film 15, whereby the light to be received does not pass through the light shielding film 15, so that color mixing can be suppressed.

As described with reference to Fig. 19 and the like in the second embodiment, at least some of the voids 14 in the solid-state imaging element 1 (1A, 1B, 1C) may be formed in a tapered shape.

The term "tapered shape" as used herein includes both a forward tapered shape and a reverse tapered shape. The void 14 is formed in a tapered shape, whereby the incident light can be appropriately reflected to the original pixel Px, so that the utilization efficiency of light can be improved and the sensitivity can be improved.

As described with reference to Fig. 19 and the like in the second embodiment, the tapered shape of the void 14 in the solid-state imaging element 1 (1A, 1B, 1C) may be a forward tapered shape as viewed from the light incident side.

For the pixel Px disposed at a position where the image height is low, light substantially parallel to the optical axis is incident; however, the void 14 having a forward tapered shape is formed, whereby the light incident near the boundary between the void 14 and the color filter 13 (13R, 13G, 13B) can be appropriately guided to the photoelectric conversion unit (photodiode PD). As a result, the light receiving sensitivity of the pixel Px can be improved. Furthermore, in particular, since the incident light can be reflected toward the substantially center of the photoelectric conversion unit by the void 14 having a forward tapered shape, the utilization efficiency of light can be further improved.

As described with reference to Fig. 20 and the like in the second embodiment, the tapered shape of the void 14 in the solid-state imaging element 1 (1A, 1B, 1C) may be a reverse tapered shape as viewed from the light incident side.

For the pixel Px disposed at a position where the image height is high, light oblique to the optical axis is incident; however, the void 14 having a reverse tapered shape is formed, whereby the light incident on the side surface of the void 14 is easily reflected to the original pixel Px. Thus, the light receiving sensitivity of the pixel Px can be improved and color mixing can be prevented.

As described with reference to Fig. 21 and the like in the second embodiment, the first void (the void 14 illustrated in Fig. 19) having a forward tapered shape as viewed from the light incident side and the second void (the void 14 illustrated in Fig. 20) having a reverse tapered shape as viewed from the light incident side may be provided as the void 14 in the solid-state imaging element 1 (1A, 1B, 1C), and the second void may be disposed at a position farther from the image height center than the first void.

As a result, the void 14 having a shape in which the incident light is easily reflected to the original pixel Px is formed as appropriate according to the arrangement position of the pixel Px. Thus, it is possible to improve the light receiving sensitivity and prevent the color mixing.

As described with reference to Fig. 27 and the like in the second embodiment, the tapered shape of the void 14 in the solid-state imaging element 1 (1A, 1B, 1C) may be formed in a shape in which the corner portion 20 is rounded.

As a result, processing for forming the corner portion 20 at an acute angle is unnecessary, and thus, it is possible to manufacture the solid-state imaging element 1 without increasing the number of steps for forming the void 14. Furthermore, it is possible to reduce the cost of the manufacturing apparatus for manufacturing the solid-state imaging element 1.

As described with reference to Fig. 28 and the like in the third embodiment, the metal film 21 may be formed between the void 14 and the photoelectric conversion unit (photodiode PD) in the solid-state imaging element 1 (1A, 1B, 1C).

As a result, at least a part of the light incident on the side surface of the void 14 is blocked without being incident on the adjacent pixel Px. Thus, the effect of preventing color mixing can be further enhanced.

As described with reference to Fig. 35 and the like in the fourth embodiment, the solid-state imaging element 1 (1A, 1B, 1C) may include the on-chip lens 17 disposed on the light incident side of the color filter 13 (13R, 13G, 13B), and the upper end portion 24 of the light shielding film 15C may be disposed on the light incident side from the boundary between the on-chip lens 17 and the color filter 13.

As a result, color mixing between the on-chip lenses 17 can be suppressed, and a high color mixing effect can be obtained as a whole.

As described with reference to Fig. 36 and the like, the imaging apparatus 100 as an electronic device includes: the optical system element (lens system 101) on which light is incident; and the solid-state imaging element 1 (1A, 1B, 1C) that receives light incident from the optical system element and outputs a pixel signal according to an amount of received light, in which the solid-state imaging element 1 includes: the photoelectric conversion unit (photodiode PD) that performs photoelectric conversion; the color filter 13 (13R, 13G, 13B) that is formed on the light incident side of the photoelectric conversion unit and selectively transmits light received by the photoelectric conversion unit; and the signal processing unit 7 that performs signal processing on the pixel signal, and the void 14 and the light shielding film 15 (15C) on the light incident side of the void 14 are formed between the color filters 13.

As such an imaging apparatus 100, not only a camera but also various types can be considered, for example, an electronic device having a camera function such as a smartphone.

Note that effects described in the present description are merely examples and are not limited, and other effects may be provided.

Furthermore, the above-described examples may be combined in any way, and the above-described various functions and effects may be obtained even in a case where various combinations are used.

### <12. Present technology>

(1) A solid-state imaging element including:
   a photoelectric conversion unit that performs photoelectric conversion; and
   a color filter that is formed on a light incident side of the photoelectric conversion unit and selectively transmits light received by the photoelectric conversion unit, in which
   a void and a light shielding film on the light incident side of the void are formed between a plurality of the color filters.
(2) The solid-state imaging element according to (1), in which
   the light shielding film includes a black negative resist.
(3) The solid-state imaging element according to any of (1) to (2), in which
   the light shielding film includes a negative resist having a light shielding property or wavelength selectivity.
(4) The solid-state imaging element according to any of (1) to (3), in which
   at least some of a plurality of the voids are formed in a tapered shape.
(5) The solid-state imaging element according to (4), in which
   the tapered shape is a forward tapered shape as viewed from the light incident side.
(6) The solid-state imaging element according to (4), in which
   the tapered shape is a reverse tapered shape as viewed from the light incident side.
(7) The solid-state imaging element according to (4), in which
   a first void and a second void are provided as the voids, the first void having a forward tapered shape as viewed from the light incident side, the second void having a reverse tapered shape as viewed from the light incident side, and
   the second void is disposed at a position farther from an image height center than the first void.
(8) The solid-state imaging element according to any of (4) to (7), in which
   the tapered shape is formed in a shape in which a corner portion is rounded.
(9) The solid-state imaging element according to any of (1) to (8), in which
   a metal film is formed between the void and the photoelectric conversion unit.
(10) The solid-state imaging element according to any of (1) to (9), further including
   an on-chip lens disposed on the light incident side of the color filter, in which
   an upper end portion of the light shielding film is disposed on the light incident side from a boundary between the on-chip lens and the color filter.
(11) An electronic device including:
   an optical system element on which light is incident; and
   a solid-state imaging element that receives light incident from the optical system element and outputs a pixel signal according to an amount of received light, in which
   the solid-state imaging element includes:
      a photoelectric conversion unit that performs photoelectric conversion;
      a color filter that is formed on a light incident side of the photoelectric conversion unit and selectively transmits light received by the photoelectric conversion unit; and
      a signal processing unit that performs signal processing on the pixel signal, and
      a void and a light shielding film on the light incident side of the void are formed between a plurality of the color filters.

### REFERENCE SIGNS LIST

1, 1A, 1B, 1C Solid-state imaging element
7 Signal processing unit
13, 13R, 13G, 13B Color filter
14 Void
15, 15C Light shielding film
17 On-chip lens
18 Resist (negative resist)
20 Corner portion
21 Metal film
24 Upper end portion
100 Imaging apparatus (electronic device)
101 Lens system (optical system element)
PD Photodiode (photoelectric conversion unit)

## Claims

1. A solid-state imaging element comprising:
a photoelectric conversion unit that performs photoelectric conversion; and
a color filter that is formed on a light incident side of the photoelectric conversion unit and selectively transmits light received by the photoelectric conversion unit, wherein
a void and a light shielding film on the light incident side of the void are formed between a plurality of the color filters.

2. The solid-state imaging element according to claim 1, wherein
the light shielding film includes a black negative resist.

3. The solid-state imaging element according to claim 1, wherein
the light shielding film includes a negative resist having a light shielding property or wavelength selectivity.

4. The solid-state imaging element according to claim 1, wherein
at least some of a plurality of the voids are formed in a tapered shape.

5. The solid-state imaging element according to claim 4, wherein
the tapered shape is a forward tapered shape as viewed from the light incident side.

6. The solid-state imaging element according to claim 4, wherein
the tapered shape is a reverse tapered shape as viewed from the light incident side.

7. The solid-state imaging element according to claim 4, wherein
a first void and a second void are provided as the voids, the first void having a forward tapered shape as viewed from the light incident side, the second void having a reverse tapered shape as viewed from the light incident side, and
the second void is disposed at a position farther from an image height center than the first void.

8. The solid-state imaging element according to claim 4, wherein
the tapered shape is formed in a shape in which a corner portion is rounded.

9. The solid-state imaging element according to claim 1, wherein
a metal film is formed between the void and the photoelectric conversion unit.

10. The solid-state imaging element according to claim 1, further comprising
an on-chip lens disposed on the light incident side of the color filter, wherein
an upper end portion of the light shielding film is disposed on the light incident side from a boundary between the on-chip lens and the color filter.

11. An electronic device comprising:
an optical system element on which light is incident; and
a solid-state imaging element that receives light incident from the optical system element and outputs a pixel signal according to an amount of received light, wherein
the solid-state imaging element includes:
a photoelectric conversion unit that performs photoelectric conversion;
a color filter that is formed on a light incident side of the photoelectric conversion unit and selectively transmits light received by the photoelectric conversion unit; and
a signal processing unit that performs signal processing on the pixel signal, and
a void and a light shielding film on the light incident side of the void are formed between a plurality of the color filters.
